# EUROPEAN PATENT SPECIFICATION

(11) **EP 3 190 207 B1**
(45) Date of publication and mention of the grant of the patent: **08.05.2019**
(21) Application number: 15837549.3
(22) Date of filing: 07.09.2015
(51) Int. Cl.: G03F 7/033, C08F 8/30, C08F 220/20, G03F 7/004, G03F 7/027, G03F 7/40, G03F 7/11

(54) **PHOTOCURABLE ELECTROLESS PLATING PRIMER**
LICHTHÄRTBARER PRIMER FÜR STROMLOSE ABSCHEIDUNG
COUCHE PRIMAIRE POUR DÉPÔT AUTOCATALYTIQUE PHOTODURCISSABLE

(30) Priority: 05.09.2014 JP 2014181469
(43) Date of publication of application: 12.07.2017
(73) Proprietor: Nissan Chemical Corporation, Tokyo (JP)
(72) Inventor: MORIMOTO, Yudai, Funabashi-shi Chiba 274-0052 (JP); KOJIMA, Keisuke, Funabashi-shi Chiba 274-0052 (JP)
(74) Representative: Hoffmann Eitle
(86) International application number: PCT/JP2015/075364
(87) International publication number: WO 2016/035896

(56) References cited:
- EP-A1- 2 058 338
- EP-A1- 2 698 448
- EP-A1- 3 190 463
- EP-A2- 1 580 595
- WO-A1-2012/141215
- WO-A1-2012/141216
- WO-A1-2014/042215
- GB-A- 2 499 663
- JP-A- H10 317 153
- JP-A- S60 110 877
- JP-A- S62 146 278
- JP-A- 2001 303 255
- JP-A- 2006 510 809
- JP-A- 2014 159 620
- US-A1- 2004 106 718
- US-A1- 2007 243 363
- HIDEO NAGASHIMA: 'CATALYSTS IN POLYMER SCIENCE : A KEY TO NEW CATALYSIS, METAL NANOPARTICLES STABILIZED BY FUNCTIONALIZED HYPERBRANCHED POLYMERS FOR CATALYSIS' KOBUNSHI vol. 63, no. 3, 01 March 2014, pages 163 - 165, XP008185308

## Description

### TECHNICAL FIELD

The present invention relates to a primer for electroless plating, and more specifically to a photocurable primer for electroless plating.

### BACKGROUND ART

Electroless plating is widely used in various fields including decorating applications for imparting a high-grade sensation and aesthetic appearance to resin molded products for automotive parts, electromagnetic shielding, wiring technologies for printed circuit boards and large scale integrated circuits, because electroless plating can produce a coating film with a uniform thickness regardless of the kind and shape of a base material simply by immersing the base material in a plating solution and can form a metal plating film also on nonconductors such as plastic, ceramic, and glass.

Generally, when a metal plating film is formed on a base material (an object to be plated) by electroless plating, a pretreatment for electroless plating is carried out for improving adhesion between the base material and the metal plating film. Specifically, the surface to be treated is roughened and/or hydrophilized by various etching means, followed by sensitization, in which an adsorbing substance that promotes adsorption of a plating catalyst on the surface to be treated is provided on the surface to be treated. Activation is then performed to allow the plating catalyst to be absorbed on the surface to be treated. Typically, sensitization involves immersion of the object to be treated in an acidic solution of stannous chloride to promote deposition of the metal (Sn²⁺) capable of acting as a reducing agent on the surface to be treated. The sensitized surface to be treated is immersed in an acidic solution of palladium chloride for activation. In this step, the palladium ion in the solution is reduced by the metal that is a reducing agent (tin ion: Sn²⁺) and deposited on the surface to be treated as an active palladium catalyst nucleus. After this pretreatment, the processed base material is immersed in an electroless plating solution to form a metal plating film on the surface to be treated.

In this way, the conventional electroless plating technique requires activation of the plating catalyst. In comparison, in a reported example, a composition including a hyperbranched polymer having an ammonium group and Pd fine particles is used as a catalyst to enable formation of electroless plating only by immersing the base material in an electroless plating solution directly without passing through an activation process after coating application (Patent Document 1).

EP 2 698 448 A1 relates to a primer for forming a metallic plating film on a substrate by electroless plating, the primer comprising: a hyperbranched polymer having an ammonium group at a molecular terminal and a weight-average molecular weight of 500 to 5,000,000; and a metal fine particle.

US 2004/106718 A1 relates to a photocurable silver composition which comprises an ultraviolet light curable organic mixture, a photoinitiator, a silver powder, and a silver flake composition. The silver flake composition comprises at least 20% of the weight of the silver powder. The disclosed compositions are said to be suitable for producing silver-containing coatings on a variety of different substrates.

GB 2 499 663 A relates to a process wherein a surface coating is applied to a photosensitive material, such as a photo-resist on a substrate, where the photosensitive material, before or after curing, and surface coating are both soluble in a first liquid. The first liquid is preferably an organic solvent and is used to remove the material / photo-resist and the coating after it has been exposed to radiation via a mask. Preferably this leaves a pattern of cured / exposed photo-resist on the substrate. To apply the coating material, it is provided as a dispersion in a second liquid, such as water and preferably as an aqueous solution, in which the photosensitive material is insoluble.

US 2007/243363 A1 relates to a resin composition which comprises a catalyst precursor for electroless plating to form an electromagnetic wave shielding layer. The resin composition comprises an organic polymer resin, a polyfunctional monomer having an ethylenically unsaturated bond, a photoinitiator, a silver organic complex precursor as a catalyst precursor, and an organic solvent. Further disclosed are methods for forming metal patterns using the resin composition and metal patterns formed by the methods. The methods comprise forming a pattern, reducing the pattern, and electroless plating the reduced pattern.

### Prior Art Documents

Patent Document 1: WO 2012/141215 Pamphlet

### SUMMARY OF THE INVENTION

### Problem to be Solved by the Invention

As described above, in the conventional electroless plating process, a chromium compound (chromic acid) is used in the roughening step carried out in the pretreatment and, moreover, many steps are required in the pretreatment. The electroless plating process thus needs some improvements in terms of environmental impact, costs, and cumbersome operation.

With the recent improvement of the technology for molding a resin housing, there is a demand for a method for plating the surface of a neatly produced housing as it is. In particular, with miniaturization in electronic circuit formation and faster transmission of electric signals, there is a demand for a method for electroless plating with stronger adhesion to a smooth substrate.

In view of such problems, the present invention is aimed to provide a new primer for electroless plating for use in the pretreatment process for electroless plating, which is environmentally friendly, can be easily treated in fewer process steps, and can provide sufficient adhesion to the substrate.

### Means for Solving the Problem

The inventors of the present invention have conducted intensive studies in order to achieve the object above and have found that a combination of a hyperbranched polymer having an ammonium group at a molecular terminal, metal fine particles, a polymerizable compound having a (meth)acryloyl group, and a photopolymerization initiator is applied on a base material to form a layer that has excellent platability and adhesion as a priming layer for electroless metal plating. This finding has led to completion of the present invention.

More specifically, according to a first aspect, the present invention relates to a photocurable primer for forming a metal plating film on a base material through an electroless plating process, the primer comprising:
(a) a hyperbranched polymer having an ammonium group at a molecular terminal and a weight average molecular weight of 1,000 to 5,000,000;
(b) metal fine particles;
(c) a polymerizable compound having a (meth)acryloyl group and having at least one structure selected from the group consisting of an oxyalkylene structure and a poly(meth)acrylic structure; and
(d) a photopolymerization initiator.

According to a second aspect, the present invention relates to the photocurable primer according to the first aspect, in which the polymerizable compound (c) is a compound having a (meth)acryloyl group and having an oxyalkylene structure.

According to a third aspect, the present invention relates to the photocurable primer according to the first aspect, in which the polymerizable compound (c) is a poly(meth)acrylic compound having a (meth)acryloyl group.

According to a fourth aspect, the present invention relates to the photocurable primer according to any one of the first aspect to the third aspect, in which the polymerizable compound (c) is a compound having two or more (meth)acryloyl groups in a molecule.

According to an fifth aspect, the present invention relates to the photocurable primer according to any one of the first aspect to the fourth aspect, in which the hyperbranched polymer (a) is a hyperbranched polymer of Formula [1]: 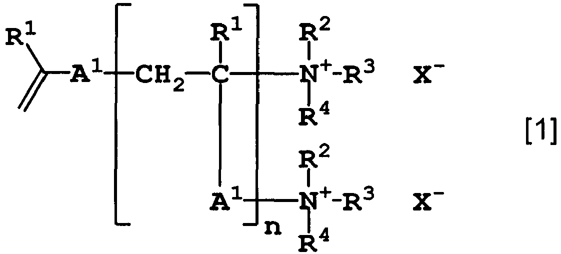 (wherein R¹ are each independently a hydrogen atom or a methyl group, R² to R⁴ are each independently a hydrogen atom, a linear, branched, or cyclic alkyl group having a carbon atom number of 1 to 20, a C₇₋₂₀ arylalkyl group, or -(CH₂CH₂O)ₘR⁵ (wherein R⁵ is a hydrogen atom or methyl group, and m is an integer of 2 to 100) (the alkyl group and the arylalkyl group are optionally substituted with an alkoxy group, a hydroxy group, an ammonium group, a carboxy group, or a cyano group), or optionally, two groups of R² to R⁴ together are a linear, branched, or cyclic alkylene group, or R² to R⁴ together with a nitrogen atom to which R² to R⁴ are bonded form a ring, X⁻ is an anion, n is the number of repeating unit structures and an integer of 5 to 100,000, and A¹ is a structure of Formula [2]): 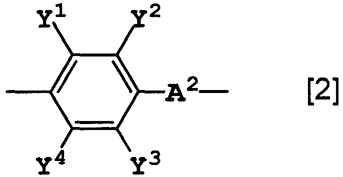 (wherein A² is a linear, branched, or cyclic alkylene group having a carbon atom number of 1 to 30 optionally containing an ether bond or an ester bond, and Y¹ to Y⁴ are each independently a hydrogen atom, a C₁₋₂₀ alkyl group, a C₁₋₂₀ alkoxy group, a nitro group, a hydroxy group, an amino group, a carboxy group, or a cyano group).

According to a sixth aspect, the present invention relates to the photocurable primer according to the fifth aspect, in which the hyperbranched polymer (a) is a hyperbranched polymer of Formula [3]: 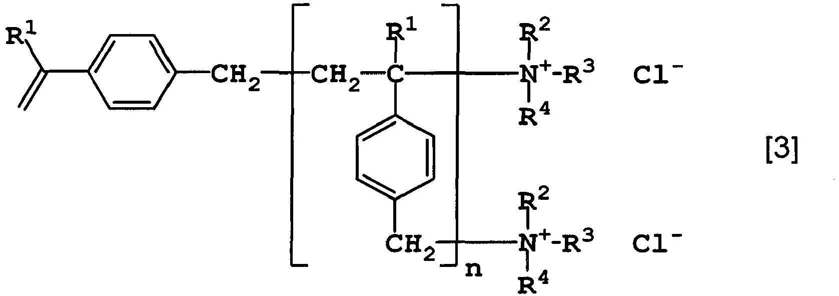 (wherein R¹ to R⁴ and n have the same meanings as described above).

According to a seventh aspect, the present invention relates to the photocurable primer according to any one of the first aspect to the sixth aspect, in which the metal fine particles (b) are fine particles of at least one of metal species selected from the group consisting of iron (Fe), cobalt (Co), nickel (Ni), copper (Cu), palladium (Pd), silver (Ag), tin (Sn), platinum (Pt), and gold (Au).

According to an eighth aspect, the present invention relates to the photocurable primer according to the seventh aspect, in which the metal fine particles (b) are palladium fine particles.

According to a ninth aspect, the present invention relates to the photocurable primer according to any one of the first aspect to the eighth aspect, in which the metal fine particles (b) are fine particles having an average particle diameter of 1 nm to 100 nm.

According to a tenth aspect, the present invention relates to a priming layer for electroless plating obtained by forming the photocurable primer as described in any one of the first aspect to the ninth aspect into a layer by photocuring.

According to a eleventh aspect, the present invention relates to a metal plating film formed on the priming layer for electroless plating as described in the tenth aspect by performing electroless plating on the priming layer.

According to a twelfth aspect, the present invention relates to a metal-coated base material comprising a base material, the priming layer for electroless plating as described in the tenth aspect formed on the base material, and the metal plating film as described in the eleventh aspect formed on the priming layer for electroless plating.

According to a thirteenth aspect, the present invention relates to a method of producing a metal-coated base material, the method comprising:
step A: applying the photocurable primer as described in any one of the first aspect to the ninth aspect on a base material to form a coating film;
step B: exposing the base material on which the photocurable primer is applied to form a priming layer; and
step C: immersing the base material with the priming layer in an electroless plating bath to form a metal plating film.

### Effects of the Invention

A priming layer for electroless metal plating can be easily formed by simply applying the primer of the present invention on a base material and photocuring the primer. The primer of the present invention can form a priming layer having excellent adhesion to the base material without forming a primer layer, which is conventionally formed on a base material in order to enhance the adhesion to the metal plating film. In addition, the primer of the present invention can provide a fine line on the order of µm and can be suitably used in a variety of wiring technologies.

A metal plating film can be easily formed simply by immersing the priming layer for electroless metal plating formed from the primer of the present invention in an electroless plating bath, and a metal-coated base material including a base material, a priming layer, and a metal plating film can be easily obtained. The metal plating film has excellent adhesion to the underlying priming layer.

That is, a metal plating film, in a sense, having excellent adhesion to a base material can be formed by forming a priming layer on a base material using the primer of the present invention.

### BRIEF DESCRIPTION OF THE DRAWINGS

FIG. 1 illustrates the ¹H NMR spectrum of a hyperbranched polymer having a chlorine atom at a molecular terminal (HPS-Cl) obtained in Production Example 1.
FIG. 2 illustrates the ¹³C NMR spectrum of a hyperbranched polymer having a dimethyloctylammonium group at a molecular terminal (HPS-N(Me)₂OctCl) produced in Production Example 2.

### MODES FOR CARRYING OUT THE INVENTION

The present invention will be described in details below.

The primer of the present invention is a photocurable primer comprising (a) a hyperbranched polymer having an ammonium group at a molecular terminal and a weight average molecular weight of 1,000 to 5,000,000, (b) metal fine particles, (c) a polymerizable compound having a (meth)acryloyl group and having at least one structure selected from the group consisting of an oxyalkylene structure and a poly(meth)acrylic structure, and (d) a photopolymerization initiator.

The primer of the present invention is suitably used as a primer for forming a metal plating film on a base material through an electroless plating process.

### [Primer]

### <(a) Hyperbranched Polymer>

The hyperbranched polymer for use in the primer of the present invention is a polymer having an ammonium group at a molecular terminal and a weight-average molecular weight of 1,000 to 5,000,000. Specific examples thereof include a hyperbranched polymer of Formula [1]. 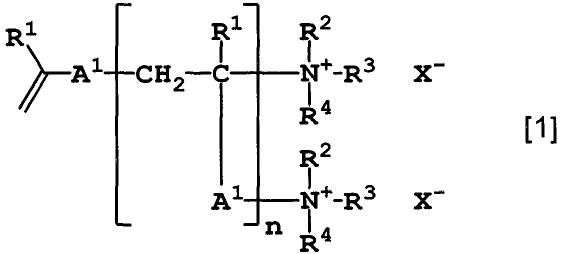
In Formula [1] above, R¹ are each independently a hydrogen atom or a methyl group.
R² to R⁴ are each independently a hydrogen atom, a linear, branched, or cyclic alkyl group having a carbon atom number of 1 to 20, a C₇₋₂₀ arylalkyl group, or -(CH₂CH₂O)ₘR⁵ (wherein R⁵ is a hydrogen atom or methyl group, and m is any integer of 2 to 100). The alkyl group and the arylalkyl group are optionally substituted with an alkoxy group, a hydroxy group, an ammonium group, a carboxy group, or a cyano group. Alternatively, two groups of R² to R⁴ may together are a linear, branched, or cyclic alkylene group, or R² to R⁴ together with a nitrogen atom to which R² to R⁴ are bonded optionally form a ring.
X⁻ is an anion, and n is the number of repeating unit structures and an integer of 5 to 100,000.

Examples of the linear alkyl group having a carbon atom number of 1 to 20 in R² to R⁴ include methyl group, ethyl group, n-propyl group, n-butyl group, n-pentyl group, n-hexyl group, n-heptyl group, n-octyl group, n-nonyl group, n-decyl group, n-undecyl group, n-dodecyl group, n-tridecyl group, n-tetradecyl group, n-pentadecyl group, n-hexadecyl group, n-heptadecyl group, n-octadecyl group, n-nonadecyl group, and n-eicosyl group. A group having eight or more carbon atoms is preferred because the primer with such a group is sparingly soluble in an electroless plating solution and, in particular, n-octyl group is preferred. Examples of the branched alkyl group include isopropyl group, isobutyl group, sec-butyl group, and tert-butyl group. Examples of the cyclic alkyl group include groups having a cyclopentyl ring or cyclohexyl ring structure.

Examples of the C₇₋₂₀ arylalkyl group in R² to R⁴ include benzyl group and phenethyl group.

Examples of the linear alkylene group that two groups of R² to R⁴ together form include methylene group, ethylene group, trimethylene group, tetramethylene group, and hexamethylene group. Examples of the branched alkylene group include methyl ethylene group, butane-1,3-diyl group, and 2-methyl propane-1,3-diyl group. Examples of the cyclic alkylene group include monocyclic, multicyclic, bridged cyclic C₃₋₃₀ alicyclic aliphatic groups. Specific examples thereof include groups having four or more carbon atoms with monocyclic, bicyclic, tricyclic, tetracyclic, or pentacyclic structures. These alkylene groups may contain a nitrogen atom, a sulfur atom, or an oxygen atom in the groups.

The ring that R² to R⁴ together with the nitrogen atom to which R² to R⁴ are bonded form in the structure of Formula [1] may contain a nitrogen atom, a sulfur atom, or an oxygen atom in the ring, and examples thereof include pyridine ring, pyrimidine ring, pyrazine ring, quinoline ring, and bipyridyl ring.

Examples of the combination of R² to R⁴ include [methyl group, methyl group, methyl group], [methyl group, methyl group, ethyl group], [methyl group, methyl group, n-butyl group], [methyl group, methyl group, n-hexyl group], [methyl group, methyl group, n-octyl group], [methyl group, methyl group, n-decyl group], [methyl group, methyl group, n-dodecyl group], [methyl group, methyl group, n-tetradecyl group], [methyl group, methyl group, n-hexadecyl group], [methyl group, methyl group, n-octadecyl group], [ethyl group, ethyl group, ethyl group], [n-butyl group, n-butyl group, n-butyl group], [n-hexyl group, n-hexyl group, n-hexyl group], and [n-octyl group, n-octyl group, n-octyl group]. Among them, the combinations of [methyl group, methyl group, n-octyl group] and [n-octyl group, n-octyl group, n-octyl group] are preferable.

Preferable examples of the anion X⁻ include a halogen atom, PF₆⁻, BF₄⁻, or perfluoroalkane sulfonate.

In Formula [1], A¹ is a structure of Formula [2]. 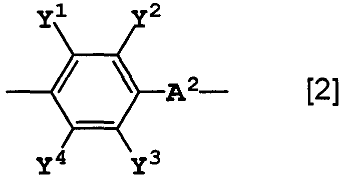
In Formula [2], A² is a linear, branched, or cyclic alkylene group having a carbon atom number of 1 to 30 optionally containing an ether bond or an ester bond.
Y¹ to Y⁴ are each independently a hydrogen atom, a C₁₋₂₀ alkyl group, a C₁₋₂₀ alkoxy group, a nitro group, a hydroxy group, an amino group, a carboxy group, or a cyano group.

Specific examples of the alkylene group of A² include linear alkylene group such as methylene group, ethylene group, trimethylene group, tetramethylene group, and hexamethylene group, and branched alkylene group such as methylethylene group, butane-1,3-diyl group, and 2-methylpropane-1,3-diyl group. Examples of the cyclic alkylene group include monocyclic, multicyclic, and bridged cyclic C₃₋₃₀ alicyclic aliphatic groups. Specific examples thereof include groups having four or more carbon atoms with monocyclic, bicyclic, tricyclic, tetracyclic, and pentacyclic structures. For example, structural examples of the alicyclic moieties (a) to (s) in the alicyclic aliphatic groups are shown below. 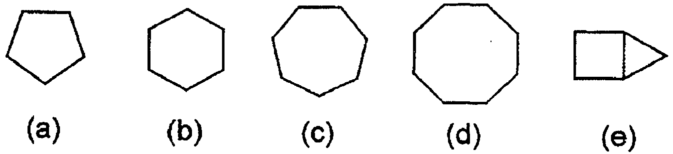 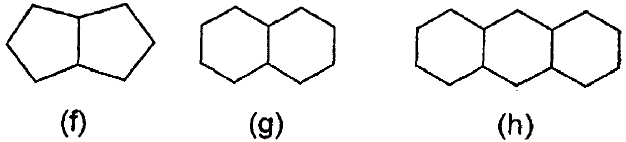 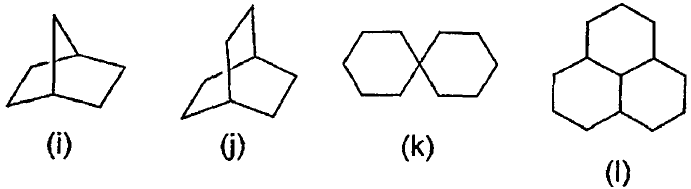 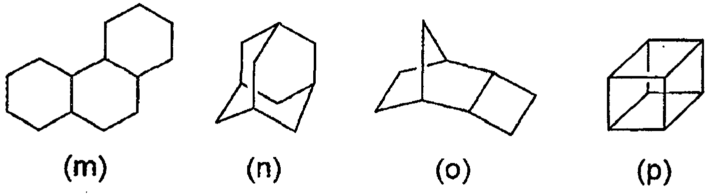 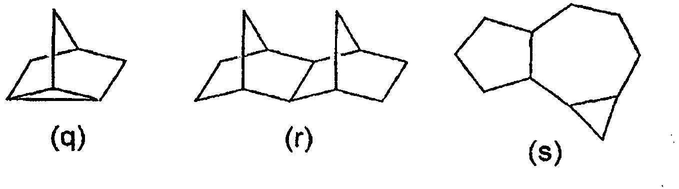 In Formula [2] above, examples of the C₁₋₂₀ alkyl group of Y¹ to Y⁴ include methyl group, ethyl group, isopropyl group, n-pentyl group, and cyclohexyl group. Examples of the C₁₋₂₀ alkoxy group include methoxy group, ethoxy group, isopropoxy group, n-pentyloxy group, and cyclohexyloxy group. Y¹ to Y⁴ are preferably a hydrogen atom or a C₁₋₂₀ alkyl group.

Preferably, examples of the hyperbranched polymer for use in the present invention include a hyperbranched polymer of Formula [3]. 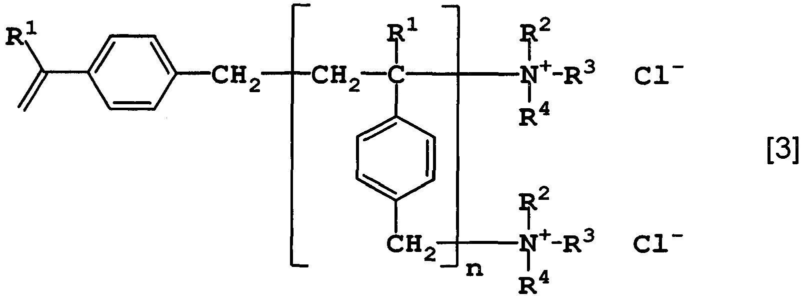 In Formula [3] above, R¹ to R⁴ and n have the same meanings as described above.

The hyperbranched polymer having an ammonium group at a molecular terminal for use in the present invention can be obtained, for example, by allowing a hyperbranched polymer having a halogen atom at a molecular terminal to react with an amine compound.

A hyperbranched polymer having a halogen atom at a molecular terminal can be produced from a hyperbranched polymer having a dithiocarbamate group at a molecular terminal according to the description of WO 2008/029688 Pamphlet. The hyperbranched polymer having a dithiocarbamate group at a molecular terminal is commercially available, and HYPERTECH (registered trademark) HPS-200 manufactured by Nissan Chemical Industries, Ltd. can be suitably used.

Examples of the amine compound that can be used in the reaction include primary amines including: aliphatic amines such as methylamine, ethylamine, n-propylamine, isopropylamine, n-butylamine, isobutylamine, sec-butylamine, tert-butylamine, n-pentylamine, n-hexylamine, n-heptylamine, n-octylamine, n-nonylamine, n-decylamine, n-undecylamine, n-dodecylamine, n-tridecylamine, n-tetradecylamine, n-pentadecylamine, n-hexadecylamine, n-heptadecylamine, n-octadecylamine, n-nonadecylamine, and n-eicosylamine; alicyclic amines such as cyclopentylamine and cyclohexylamine; aralkyl amines such as benzylamine and phenethylamine; and aromatic amines, for example, anilines such as aniline, p-n-butylaniline, p-tert-butylaniline, p-n-octylaniline, p-n-decylaniline, p-n-dodecylaniline, and p-n-tetradecylaniline, naphthylamines such as 1 -naphthylamine and 2-naphthylamine, aminoanthracenes such as 1-aminoanthracene and 2-aminoanthracene, aminoanthraquinones such as 1-aminoanthraquinone, aminobiphenyls such as 4-aminobiphenyl and 2-aminobiphenyl, aminofluorenes such as 2-aminofluorene, 1-amino-9-fluorenone, and 4-amino-9-fluorenone, aminoindanes such as 5-aminoindane, aminoisoquinolines such as 5-aminoisoquinoline, and aminophenanthrenes such as 9-aminophenanthrene. Further examples thereof include amine compounds such as N-(tert-butoxycarbonyl)-1,2-ethylenediamine, N-(tert-butoxycarbonyl)-1,3-propylenediamine, N-(tert-butoxycarbonyl)-1,4-butylenediamine, N-(tert-butoxycarbonyl)-1,5-pentamethylenediamine, N-(tert-butoxycarbonyl)-1,6-hexamethylenediamine, N-(2-hydroxyethyl)amine, N-(3-hydroxypropyl)amine, N-(2-methoxyethyl)amine, and N-(2-ethoxyethyl)amine.

Examples of secondary amines include aliphatic amines such as dimethylamine, diethylamine, di-n-propylamine, diisopropylamine, di-n-butylamine, diisobutylamine, di-sec-butylamine, di-n-pentylamine, ethylmethylamine, methyl-n-propylamine, methyl-n-butylamine, methyl-n-pentylamine, ethylisopropylamine, ethyl-n-butylamine, ethyl-n-pentylamine, methyl-n-octylamine, methyl-n-decylamine, methyl-n-dodecylamine, methyl-n-tetradecylamine, methyl-n-hexadecylamine, methyl-n-octadecylamine, ethylisopropylamine, ethyl-n-octylamine, di-n-hexylamine, di-n-octylamine, di-n-dodecylamine, di-n-hexadecylamine, and di-n-octadecylamine; alicyclic amines such as dicyclohexylamine; aralkyl amines such as dibenzylamine; aromatic amines such as diphenylamine; and nitrogen-containing heterocyclic compounds such as phthalimide, pyrrole, piperidine, piperazine, and imidazole. Further examples thereof include bis(2-hydroxyethyl)amine, bis(3-hydroxypropyl)amine, bis(2-ethoxyethyl)amine, and bis(2-propoxyethyl)amine.

Examples of tertiary amines include aliphatic amines such as trimethylamine, triethylamine, tri-n-propylamine, tri-n-butylamine, tri-n-pentylamine, tri-n-hexylamine, tri-n-octylamine, tri-n-dodecylamine, dimethylethylamine, dimethyl-n-butylamine, dimethyl-n-hexylamine, dimethyl-n-octylamine, dimethyl-n-decylamine, diethyl-n-decylamine, dimethyl-n-dodecylamine, dimethyl-n-tetradecylamine, dimethyl-n-hexadecylamine, dimethyl-n-octadecylamine, and dimethyl-n-eicosylamine; and nitrogen-containing heterocyclic compounds such as pyridine, pyrazine, pyrimidine, quinoline, 1-methylimidazole, 4,4'-bipyridyl, and 4-methyl-4,4'-bipyridyl.

The amine compound can be used in the reaction in 0.1 molar equivalent to 20 molar equivalents, preferably 0.5 molar equivalent to 10 molar equivalents, and more preferably 1 molar equivalent to 5 molar equivalents per mole of halogen atom of the hyperbranched polymer having a halogen atom at a molecular terminal.

The reaction between the hyperbranched polymer having a halogen atom at a molecular terminal and the amine compound can be carried out in water or an organic solvent in the presence or absence of a base. The solvent used is preferably capable of dissolving the hyperbranched polymer having a halogen atom at a molecular terminal and the amine compound. A solvent capable of dissolving the hyperbranched polymer having a halogen atom at a molecular terminal and the amine compound and incapable of dissolving a hyperbranched polymer having an ammonium group at a molecular terminal is more suitable for easy isolation.

Any solvent may be used in the reaction as long as the solvent does not substantially inhibit the progress of the reaction, and examples thereof include water; alcohols such as 2-propanol; organic acids such as acetic acid; aromatic hydrocarbons such as benzene, toluene, xylene, ethylbenzene, and 1,2-dichlorobenzene; ethers such as tetrahydrofuran (THF) and diethyl ether; ketones such as acetone, methyl ethyl ketone (MEK), methyl isobutyl ketone (MIBK), and cyclohexanone; halides such as chloroform, dichloromethane, and 1,2-dichloroethane; aliphatic hydrocarbons such as n-hexane, n-heptane, and cyclohexane; and amides such as N,N-dimethylformamide (DMF), N,N-dimethylacetamide, and N-methyl-2-pyrrolidone (NMP). These solvents may be used singly or in combination of two or more. The amount of the solvent used is 0.2 to 1,000 times, preferably 1 to 500 times, more preferably 5 to 100 times, and most preferably 5 to 50 times the mass of the hyperbranched polymer having a halogen atom at a molecular terminal.

As a suitable base, commonly used are inorganic compounds including alkali metal hydroxides and alkaline-earth metal hydroxides (for example, sodium hydroxide, potassium hydroxide, and calcium hydroxide), alkali metal oxides and alkaline-earth metal oxides (for example, lithium oxide, and calcium oxide), alkali metal hydrides and alkaline-earth metal hydrides (for example, sodium hydride, potassium hydride, and calcium hydride), alkali metal amides (for example, sodium amide), alkali metal carbonates and alkaline-earth metal carbonates (for example, lithium carbonate, sodium carbonate, potassium carbonate, and calcium carbonate), and alkali metal bicarbonates (for example, sodium bicarbonate), and organometallic compounds including alkali metal alkyls, alkyl magnesium halides, alkali metal alkoxides, alkaline-earth metal alkoxides, and dimethoxymagnesium. Potassium carbonate and sodium carbonate are particularly preferable. It is preferable that the base is used in 0.2 molar equivalent to 10 molar equivalents, preferably 0.5 molar equivalent to 10 molar equivalents, and most preferably 1 molar equivalent to 5 molar equivalents per mole of halogen atom of the hyperbranched polymer having a halogen atom at a molecular terminal.

In this reaction, oxygen in the reaction system is preferably sufficiently removed before this reaction is started, and the system may be purged with inert gases such as nitrogen and argon. The reaction condition is appropriately selected from the reaction time of 0.01 hour to 100 hours and the reaction temperature of 0°C to 300°C. Preferably, the reaction time is 0.1 hour to 72 hours, and the reaction temperature is 20°C to 150°C.

When a tertiary amine is used, the hyperbranched polymer of Formula [1] can be obtained whether or not a base is present.

When a primary amine or a secondary amine compound is reacted with a hyperbranched polymer having a halogen atom at a molecular terminal in the absence of a base, a hyperbranched polymer with a terminal ammonium group, in which the corresponding secondary amine terminal group or tertiary amine terminal group of hyperbranched polymer is protonated, can be obtained. Even when a base is used in the reaction, the reactant may be mixed with an aqueous solution of an acid such as hydrogen chloride, hydrogen bromide, and hydrogen iodide in an organic solvent to obtain a hyperbranched polymer with a terminal ammonium group, in which the corresponding secondary amine terminal group or tertiary amine terminal group of the corresponding hyperbranched polymer is protonated.

The weight-average molecular weight Mw of the hyperbranched polymer measured by gel permeation chromatography in terms of polystyrene is 1,000 to 5,000,000, more preferably 2,000 to 200,000, and most preferably 3,000 to 100,000. The degree of distribution Mw (weight-average molecular weight)/Mn (number-average molecular weight) is 1.0 to 7.0, preferably 1.1 to 6.0, and more preferably 1.2 to 5.0.

### <(b) Metal Fine Particles>

The metal fine particles for use in the primer of the present invention are not limited, and examples of metal species include iron (Fe), cobalt (Co), nickel (Ni), copper (Cu), palladium (Pd), silver (Ag), tin (Sn), platinum (Pt), and gold (Au), and alloys thereof. These metals may be used singly or in combination of two or more. Among these, preferable metal fine particles include palladium fine particles. Oxides of the metals may also be used as metal fine particles.

The metal fine particles are obtained by reduction of a metal ion, for example, by irradiating an aqueous solution of a metal salt with a high-pressure mercury lamp or adding a compound having a reducing action (reducing agent) to the aqueous solution. For example, a metal ion may be reduced by, for example, adding an aqueous solution of a metal salt to a solution in which the hyperbranched polymer is dissolved and irradiating the resultant mixture with ultraviolet light or adding an aqueous solution of a metal salt and a reducing agent to the hyperbranched polymer solution, to form a complex of the hyperbranched polymer and the metal fine particles, concurrently with the preparation of a primer including the hyperbranched polymer and the metal fine particles.

Examples of the metal salt include chloroauric acid, silver nitrate, copper sulfate, copper nitrate, copper acetate, tin chloride, platinous chloride, chloroplatinic acid, Pt(dba)₂ [dba=dibenzylideneacetone], Pt(cod)₂ [cod=1,5-cyclooctadiene], Pt(CH₃)₂(cod), palladium chloride, palladium acetate (Pd(OC(=O)CH₃)₂), palladium nitrate, Pd₂(dba)₃·CHCl₃, Pd(dba)₂, rhodium chloride, rhodium acetate, ruthenium chloride, ruthenium acetate, Ru(cod)(cot) [cot=cyclooctatriene], iridium chloride, iridium acetate, and Ni(cod)₂.

The reducing agent is not limited, and various reducing agents can be used. A reducing agent is preferably selected depending on, for example, the metal species added in the intended primer. Examples of the reducing agent that can be used include metal borohydrides such as sodium borohydride and potassium borohydride; aluminum hydrides such as lithium aluminum hydride, potassium aluminum hydride, cesium aluminum hydride, beryllium aluminum hydride, magnesium aluminum hydride, and calcium aluminum hydride; hydrazine compounds; citric acid and salts thereof; succinic acid and salts thereof; ascorbic acid and salts thereof; primary or secondary alcohols such as methanol, ethanol, 2-propanol, and polyol; tertiary amines such as trimethylamine, triethylamine, diisopropylethylamine, diethylmethylamine, tetramethylethylenediamine (TMEDA), and ethylenediaminetetraacetic acid (EDTA); hydroxylamines; and phosphines such as tri-n-propylphosphine, tri-n-butylphosphine, tricyclohexylphosphine, tribenzylphosphine, triphenylphosphine, triethoxyphosphine, 1,2-bis(diphenylphosphino)ethane (DPPE), 1,3-bis(diphenylphosphino)propane (DPPP), 1,1'-bis(diphenylphosphino)ferrocene (DPPF), and 2,2'-bis(diphenylphosphino)-1,1'-binaphthyl (BINAP).

The average particle diameter of the metal fine particles is preferably 1 nm to 100 nm. When the average particle diameter of the metal fine particles is 100 nm or less, the surface area is less reduced, and a satisfactory catalytic activity is achieved. The average particle diameter is further preferably 75 nm or less and particularly preferably 1 nm to 30 nm.

The amount of the hyperbranched polymer (a) added in the primer of the present invention is preferably 50 parts by mass to 2,000 parts by mass with respect to 100 parts by mass of the metal fine particles (b). With 50 parts by mass or more, the metal fine particles can be sufficiently dispersed. With 2,000 parts by mass or less, any problems in physical properties resulting from the increase in organic contents can be prevented. More preferably, the amount of the hyperbranched polymer is 100 parts by mass to 1,000 parts by mass.

### <(c) Polymerizable Compound Having a (Meth)acryloyl Group>

The polymerizable compound having a (meth)acryloyl group for use in the primer of the present invention is a compound having a (meth)acryloyl group and having at least one structure selected from the group consisting of an oxyalkylene structure and a poly(meth)acrylic structure, and preferably a compound having a (meth)acryloyl group and an oxyalkylene structure. In particular, the polymerizable compound is preferably a compound having a (meth)acryloyl group and having an oxyalkylene structure or a poly(meth)acrylic compound having a (meth)acryloyl group. The polymerizable compound having a (meth)acryloyl group preferably has two or more (meth)acryloyl groups in a molecule.

Examples of the oxyalkylene structure include a structure having oxyalkylene group. Preferable examples of the oxyalkylene group include C₂₋₄ oxyalkylene groups. Among these, an oxyethylene group [-OCH₂CH₂-] or an oxypropylene group [-OCH₂C(CH₃)H-] is preferable. A plurality of oxyalkylene groups may be coupled to form a poly(oxyalkylene) group. In this case, the poly(oxyalkylene) group has one kind of the oxyalkylene group singly used, or has two or more kinds of the oxyalkylene group in combination. When the poly(oxyalkylene) group has different kinds of the oxyalkylene groups, the bonding thereof may be either one of block bonding and random bonding.

As used in the present invention, the (meth)acrylate compound refers to both an acrylate compound and a methacrylate compound. For example, (meth)acrylic acid refers to acrylic acid and methacrylic acid.

### [Compound having a (meth)acryloyl group and having an oxyalkylene structure]

Examples of such a compound include organic compounds described in (1) to (5) below.

### (1) Monofunctional (having one (meth)acryloyl group) compound

Examples of a compound having one (meth)acryloyl group and having an oxyalkylene structure include 2-phenoxyethyl (meth)acrylate, ethylene oxide-modified o-phenylphenol (meth)acrylate, ethylene glycol monomethyl ether (meth)acrylate, ethylene glycol monoethyl ether (meth)acrylate, diethylene glycol mono(meth)acrylate, diethylene glycol monomethyl ether (meth)acrylate, diethylene glycol monoethyl ether (meth)acrylate, diethylene glycol monobutyl ether (meth)acrylate, diethylene glycol mono(2-ethylhexyl) ether (meth)acrylate, diethylene glycol monophenyl ether (meth)acrylate, triethylene glycol monomethyl ether (meth)acrylate, tetraethylene glycol monomethyl ether (meth)acrylate, tetraethylene glycol monolauryl ether (meth)acrylate, tetraethylene glycol mono(nonylphenyl) ether (meth)acrylate, octaethylene glycol mono(meth)acrylate, nonaethylene glycol monomethyl ether (meth)acrylate, decaethylene glycol mono(meth)acrylate, tridecaethylene glycol monomethyl ether (meth)acrylate, polyethylene glycol mono(meth)acrylate, polyethylene glycol monomethyl ether (meth)acrylate, dipropylene glycol monomethyl ether (meth)acrylate, tripropylene glycol mono(meth)acrylate, tetrapropylene glycol mono(meth)acrylate, pentapropylene glycol mono(nonylphenyl) ether (meth)acrylate, hexapropylene glycol mono(meth)acrylate, nonapropylene glycol mono(meth)acrylate, tridecapropylene glycol mono(meth)acrylate, polypropylene glycol mono(meth)acrylate, and polypropylene glycol monomethyl ether (meth)acrylate.

As the monofunctional compound, a commercially available product can be suitably used. Examples thereof include 2-MTA, MPE400A, MPE550A, Viscoat #192, Viscoat #192D, Viscoat #190, and Viscoat #MTG [all of the above are manufactured by Osaka Organic Chemical Industry Ltd.]; LIGHT ACRYLATE EC-A, LIGHT ACRYLATE MTG-A, LIGHT ACRYLATE EHDG-AT, LIGHT ACRYLATE 130A, LIGHT ACRYLATE DPM-A, LIGHT ACRYLATE PO-A, LIGHT ACRYLATE P2H-A, LIGHT ACRYLATE P-200A, LIGHT ACRYLATE NP-4EA, LIGHT ESTER BC, LIGHT ESTER 130MA, LIGHT ESTER 041MA, and LIGHT ESTER PO [all of the above are manufactured by KYOEISHA CHEMICAL Co., LTD.]; NK Ester A-LEN-10, NK Ester AM-90G, NK Ester AM-130G, NK Ester AMP-20GY, NK Ester M-90G, NK Ester M-230G, and NK Ester PHE-1G [all of the above are manufactured by Shin-Nakamura Chemical Co., Ltd.]; EBECRYL (registered trademark) 110 and EBECRYL 114 [all of the above are manufactured by DAICEL-ALLNEX LTD.]; BLEMMER (registered trademark) AE-90U, BLEMMER AE-200, BLEMMER AE-400, BLEMMER AP-150, BLEMMER AP-400, BLEMMER AP-550, BLEMMER AP-800, BLEMMER AME-400, BLEMMER ALE-200, BLEMMER ANP-300, BLEMMER 75ANEP-600, BLEMMER AAE-300, BLEMMER PE-90, BLEMMER PE-200, BLEMMER PE-350, BLEMMER PE-350G, BLEMMER PP-1000, BLEMMER PP-500, BLEMMER PP-800, BLEMMER 50PEP-300, BLEMMER 70PEP-350B, BLEMMER 55PET-800, BLEMMER 10PPB-500B, BLEMMER PME-100, BLEMMER PME-200, BLEMMER PME-400, BLEMMER PME-1000, BLEMMER PME-4000, BLEMMER 50POEP-800B, BLEMMER PLE-200, BLEMMER PLE-1300, BLEMMER PSE-1300, BLEMMER PAE-100, and BLEMMER 43PAPE-600B [all of the above are manufactured by NOF CORPORATION].

### (2) Bifunctional (having two (meth)acryloyl groups) compound

Examples of a compound having two (meth)acryloyl groups and having an oxyalkylene structure include diethylene glycol di(meth)acrylate, triethylene glycol di(meth)acrylate, tetraethylene glycol di(meth)acrylate, heptaethylene glycol di(meth)acrylate, nonaethylene glycol di(meth)acrylate, tetradecaethylene glycol di(meth)acrylate, polyethylene glycol di(meth)acrylate, dipropylene glycol di(meth)acrylate, tripropylene glycol di(meth)acrylate, heptapropylene glycol di(meth)acrylate, polypropylene glycol di(meth)acrylate, tri(tetramethylene glycol) di(meth)acrylate, nona(tetramethylene glycol) di(meth)acrylate, poly(tetramethylene glycol) di(meth)acrylate, propylene oxide-modified neopentyl glycol di(meth)acrylate, ethylene oxide-modified bisphenol A di(meth)acrylate [the number of moles of ethylene oxide added: 2 to 30], propylene oxide-modified bisphenol A di(meth)acrylate [the number of moles of propylene oxide added: 2 to 30], ethylene oxide-propylene oxide-modified bisphenol A di(meth)acrylate, and 9,9-bis (4-(2-((meth)acryloyloxy)ethoxy)phenyl) fluorene.

As the bifunctional compound, a commercially available product can be suitably used. Examples thereof include Viscoat #310HP, Viscoat #335HP, and Viscoat #700HV [all of the above are manufactured by Osaka Organic Chemical Industry Ltd.]; LIGHT ACRYLATE 3EG-A, LIGHT ACRYLATE 4EG-A, LIGHT ACRYLATE 9EG-A, LIGHT ACRYLATE 14EG-A, LIGHT ACRYLATE PTMGA-250, LIGHT ACRYLATE BP-4EAL, LIGHT ACRYLATE BP-4PA, LIGHT ESTER 2EG, LIGHT ESTER 3EG, LIGHT ESTER 4EG, LIGHT ESTER 9EG, LIGHT ESTER 14EG, and LIGHT ESTER BP-2EMK [all of the above are manufactured by KYOEISHA CHEMICAL Co., LTD.]; NK Ester A-200, NK Ester A-400, NK Ester A-600, NK Ester A-B1206PE, NK Ester ABE-300, NK Ester A-BPE-4, NK Ester A-BPE-10, NK Ester A-BPE-20, NK Ester A-BPE-30, NK Ester A-BPEF, NK Ester A-BPP-3, NK Ester APG-100, NK Ester APG-200, NK Ester APG-400, NK Ester APG-700, NK Ester A-PTMG-65, NK Ester 2G, NK Ester 3G, NK Ester 4G, NK Ester 9G, NK Ester 14G, NK Ester 23G, NK Ester BPE-80N, NK Ester BPE-100, NK Ester BPE-200, NK Ester BPE-500, NK Ester BPE-900, NK Ester BPE-1300N, NK Ester 1206PE, and NK Ester 9PG [all of the above are manufactured by Shin-Nakamura Chemical Co., Ltd.]; DPGDA, TPGDA, PEG400DA-D, EBECRYL (registered trademark) 145, EBECRYL 150, and EBECRYL 11 [all of the above are manufactured by DAICEL-ALLNEX LTD.]; and BLEMMER (registered trademark) ADE-200, BLEMMER ADE-3 00, BLEMMER ADE-400, BLEMMER ADE-600, BLEMMER ADP-400, BLEMMER ADT-250, BLEMMER ADC series, BLEMMER PDE-100, BLEMMER PDE-150, BLEMMER PDE-200, BLEMMER PDE-400, BLEMMER PDE-600, BLEMMER PDP-400N, BLEMMER PDT-650, BLEMMER PDC series, BLEMMER PDBE-200, BLEMMER PDBE-250, BLEMMER PDBE-450, BLEMMER PDBE-1300, and BLEMMER PDBPE series [all of the above are manufactured by NOF CORPORATION].

### (3) Trifunctional (having three (meth)acryloyl groups) compound

Examples of a compound having three (meth)acryloyl groups and having an oxyalkylene structure include ethylene oxide-modified 1,1,1-trimethylolethane tri(meth)acrylate [the number of moles of ethylene oxide added: 3 to 30], ethylene oxide-modified trimethylolpropane tri(meth)acrylate [the number of moles of ethylene oxide added: 3 to 30], propylene oxide-modified trimethylolpropane tri(meth)acrylate [the number of moles of propylene oxide added: 3 to 30], ethylene oxide-modified glycerol tri(meth)acrylate [the number of moles of ethylene oxide added: 3 to 30], propylene oxide-modified glycerol tri(meth)acrylate [the number of moles of propylene oxide added: 3 to 30], tris(2-(acryloyloxy)ethyl)isocyanurate, and ε-caprolactone-modified tris(2-(acryloyloxy)ethyl)isocyanurate [the number of moles of ε-caprolactone added: 1 to 30].

As the trifunctional compound, a commercially available product can be suitably used, and examples thereof include Viscoat #360 [manufactured by Osaka Organic Chemical Industry Ltd.]; NK Ester A-GLY-9E, NK Ester A-GLY-20E, NK Ester AT-20E [all of the above are manufactured by Shin-Nakamura Chemical Co., Ltd.]; and TMPEOTA, OTA480, and EBECRYL (registered trademark) 135 [all of the above are manufactured by DAICEL-ALLNEX LTD.].

### (4) Tetrafunctional (having four (meth)acryloyl groups) compound

Examples of a compound having four (meth)acryloyl groups and having an oxyalkylene structure include ethylene oxide-modified ditrimethylolpropane tetra(meth)acrylate [the number of moles of ethylene oxide added: 4 to 40] and ethylene oxide-modified pentaerythritol tetra(meth)acrylate [the number of moles of ethylene oxide added: 4 to 40].

As the tetrafunctional compound, a commercially available product can be suitably used, and examples thereof include NK Ester ATM-4E, and NK Ester ATM-35E [all of the above are manufactured by Shin-Nakamura Chemical Co., Ltd.]; and EBECRYL (registered trademark) 40 [manufactured by DAICEL-ALLNEX LTD.].

### (5) Penta- or more functional (having five or more (meth)acryloyl groups) compound

Examples of a compound having five or more (meth)acryloyl groups and having an oxyalkylene structure include ethylene oxide-modified dipentaerythritol hexa(meth)acrylate [the number of moles of ethylene oxide added: 6 to 60] and ethylene oxide-modified tripentaerythritol octa(meth)acrylate [the number of moles of ethylene oxide added: 6 to 60].

As the penta- or more functional compound, a commercially available product can be suitably used, and examples thereof include NK Ester A-DPH-12E [manufactured by Shin-Nakamura Chemical Co., Ltd.].

### [Urethane (meth)acrylate compound]

Examples of such a compound include organic compounds described in (1) to (6) below.

### (1) Monofunctional (having one (meth)acryloyl group) urethane (meth)acrylate

A compound having one (meth)acryloyl group and having a urethane structure is not limited to specific examples. For example, polyisocyanate (isocyanate component) is reacted with mono-ol (active hydrogen component) to obtain an isocyanate terminal prepolymer, which is then reacted with a compound having a (meth)acryloyl group and a group reactive with isocyanate to yield a urethane (meth)acrylate having one (meth)acryloyl group on average per molecule. Polyol may be used instead of mono-ol. In this case, manipulation is necessary such that a (meth)acryloyloxy group is not introduced to part of the terminal hydroxy group of the polyol.

### (2) Bifunctional (having two (meth)acryloyl groups) urethane (meth)acrylate

Examples of a compound having two (meth)acryloyl groups and having a urethane structure include a urethane product of a (meth)acrylic acid adduct of phenyl glycidyl ether and hexamethylene diisocyanate, and a urethane product of a (meth)acrylic acid adduct of phenyl glycidyl ether and toluene diisocyanate.

As the bifunctional urethane (meth)acrylate, a commercially available product can be suitably used. Examples thereof include AH-600 and AT-600 [all of the above are manufactured by KYOEISHA CHEMICAL Co., LTD.]; NK Oligo U-2PPA, NK Oligo U-200PA, NK Oligo UA-160TM, NK Oligo UA-290TM, NK Oligo UA-4200, NK Oligo UA-4400, NK Oligo UA-122P, and NK Oligo UA-W2A [all of the above are manufactured by Shin-Nakamura Chemical Co., Ltd.]; EBECRYL (registered trademark) 210, EBECRYL 215, EBECRYL 230, EBECRYL 244, EBECRYL 245, EBECRYL 270, EBECRYL 280/15IB, EBECRYL 284, EBECRYL 285, EBECRYL 4858, EBECRYL 8307, EBECRYL 8402, EBECRYL 8411, EBECRYL 8804, EBECRYL 8807, EBECRYL 9227EA, EBECRYL 9270, and KRM (registered trademark) 7735 [all of the above are manufactured by DAICEL-ALLNEX LTD.]; and SHIKOH (registered trademark) UV-6630B, SHIKOH UV-7000B, SHIKOH UV-7461TE, SHIKOH UV-2000B, SHIKOH UV-2750B, SHIKOH UV-3000, SHIKOH UV-3200B, SHIKOH UV-3210EA, SHIKOH UV-3300B, SHIKOH UV-3310B, SHIKOH UV-3500BA, SHIKOH UV-3520TL, SHIKOH UV-3700B, and SHIKOH UV-6640B [all of the above are manufactured by The Nippon Synthetic Chemical Industry Co., Ltd.].

### (3) Trifunctional (having three (meth)acryloyl groups) urethane (meth)acrylate

Examples of commercially available products of a compound having three (meth)acryloyl groups and having a urethane structure include NK Oligo UA-7100 [manufactured by Shin-Nakamura Chemical Co., Ltd.]; EBECRYL (registered trademark) 204, EBECRYL 205, EBECRYL 264, EBECRYL 265, EBECRYL 294/25HD, EBECRYL 1259, EBECRYL 4820, EBECRYL 8311, EBECRYL 8465, EBECRYL 8701, EBECRYL 9260, KRM (registered trademark) 8296, and KRM 8667 [all of the above are manufactured by DAICEL-ALLNEX LTD.]; and SHIKOH (registered trademark) UV-7550B, SHIKOH UV-7000B, SHIKOH UV-7510B, SHIKOH UV-7461TE, and SHIKOH UV-2750B [all of the above are manufactured by The Nippon Synthetic Chemical Industry Co., Ltd.].

### (4) Tetrafunctional (having four (meth)acryloyl groups) urethane (meth)acrylate

Examples of commercially available products of a compound having four (meth)acryloyl groups and having a urethane structure include EBECRYL (registered trademark) 8210, EBECRYL 8405, and KRM (registered trademark) 8528 [all of the above are manufactured by DAICEL-ALLNEX LTD.]; and SHIKOH (registered trademark) UV-7650B [manufactured by The Nippon Synthetic Chemical Industry Co., Ltd.].

### (5) Penta- or more functional (having five or more (meth)acryloyl groups) urethane (meth)acrylate

Examples of a compound having five or more (meth)acryloyl groups and having a urethane structure include a urethane product of pentaerythritol tri(meth)acrylate and hexamethylene diisocyanate, a urethane product of pentaerythritol tri(meth)acrylate and toluene diisocyanate, a urethane product of pentaerythritol tri(meth)acrylate and isophorone diisocyanate, and a urethane product of dipentaerythritol penta(meth)acrylate and hexamethylene diisocyanate.

As the penta- or more functional urethane (meth)acrylate, a commercially available product can be suitably used. Examples thereof include UA-306H, UA-306T, UA-306I, and UA-510H [all of the above are manufactured by KYOEISHA CHEMICAL Co.,LTD]; NK Oligo U-6LPA, NK Oligo U-10HA, NK Oligo U-10PA, NK Oligo U-1100H, NK Oligo U-15HA, NK Oligo UA-53H, and NK Oligo UA-33H [all of the above are manufactured by Shin-Nakamura Chemical Co., Ltd.]; EBECRYL (registered trademark) 220, EBECRYL 1290, EBECRYL 5129, EBECRYL 8254, EBECRYL 8301R, KRM (registered trademark) 8200, KRM 8200AE, KRM 8904, and KRM 8452 [all of the above are manufactured by DAICEL-ALLNEX LTD.]; and SHIKOH (registered trademark) UV-1700B, SHIKOH UV-6300B, SHIKOH UV-7600B, SHIKOH UV-7605B, SHIKOH UV-7610B, SHIKOH UV-7620EA, SHIKOH UV-7630B, SHIKOH UV-7640B, and SHIKOH UV-7650B [all of the above are manufactured by The Nippon Synthetic Chemical Industry Co., Ltd.].

### (6) Polyurethane (meth)acrylate

As the polyurethane (meth)acrylate, a commercially available product can be suitably used. Examples thereof include polyurethane (meth)acrylates having a urethane structure at a side chain such as ACRIT 8BR-500, ACRIT 8BR-600, and ACRIT 8BR-930M [all of the above are manufactured by TAISEI FINE CHEMICAL CO., LTD.]; and polyurethane (meth)acrylates having a urethane structure at a main chain such as ACRIT 8UH-1006 and ACRIT 8UH-1012 [all of the above are manufactured by TAISEI FINE CHEMICAL CO., LTD.].

### [Poly(meth)acrylic compound having a (meth)acryloyl group]

Such a compound is not limited as long as the compound is a (meth)acrylic polymer having a (meth)acryloyl group at a side chain. Such a polymer (also called (meth)acrylic (meth)acrylate) is obtained, for example, by polymerizing a (meth)acrylic monomer including (meth)acrylate having a reactive group as a monomer component and reacting the obtained polymer with a compound having a functional group reactive with the reactive group and a (meth)acryloyl group.

As the (meth)acrylic (meth)acrylate, a commercially available product can be suitably used. Examples thereof include ACRIT 8KX-077, ACRIT 8KX-078, ACRIT 8KX-127, ACRIT 8KX-128, ACRIT 8KX-012C, ACRIT 8KX-014C, ACRIT 8KX-018C, ACRIT 8KX-052C, and ACRIT 8KQ-2001 [all of the above are manufactured by TAISEI FINE CHEMICAL CO., LTD.]; and SMP-220A, SMP-250A, SMP-360A, and SMP-550A [all of the above are manufactured by KYOEISHA CHEMICAL Co., LTD.].

The polymerizable compound having a (meth)acryloyl group for use in the primer of the present invention is also preferably a compound having two or more (meth)acryloyl groups in a molecule, other than the compound having a (meth)acryloyl group and at least one structure selected from the group consisting of an oxyalkylene structure, a urethane structure, and a poly(meth)acrylic structure.

### [Other compounds having a (meth)acryloyl group]

Examples of polymerizable compounds other than the compound having a (meth)acryloyl group and an oxyalkylene structure and the poly(meth)acrylic compound having a (meth)acryloyl group, include organic compounds described in (1) to (5) below.

### (1) Monofunctional (having one (meth)acryloyl group) compound

Examples of a compound having one (meth)acryloyl group include methyl (meth)acrylate, ethyl (meth)acrylate, propyl (meth)acrylate, butyl (meth)acrylate, isobutyl (meth)acrylate, tert-butyl (meth)acrylate, isoamyl (meth)acrylate, hexyl (meth)acrylate, cyclohexyl (meth)acrylate, octyl (meth)acrylate, isooctyl (meth)acrylate, 2-ethylhexyl (meth)acrylate, nonyl (meth)acrylate, isononyl (meth)acrylate, 3,5,5-trimethylhexyl (meth)acrylate, decyl (meth)acrylate, isodecyl (meth)acrylate, 4-tert-butylcyclohexyl (meth)acrylate, adamantyl (meth)acrylate, norbornenyl (meth)acrylate, isobornyl (meth)acrylate, menthyl (meth)acrylate, undecyl (meth)acrylate, lauryl (meth)acrylate, tridecyl (meth)acrylate, palmityl (meth)acrylate, stearyl (meth)acrylate, isostearyl (meth)acrylate, behenyl (meth)acrylate, benzyl (meth)acrylate, glycidyl (meth)acrylate, tetrahydrofurfuryl (meth)acrylate, 2-hydroxyethyl (meth)acrylate, 2-hydroxypropyl (meth)acrylate, glycerol mono(meth)acrylate, 2-hydroxy-3-phenoxypropyl (meth)acrylate, 2-hydroxybutyl (meth)acrylate, 4-hydroxybutyl (meth)acrylate, 2-hydroxyethyl 2-((meth)acryloyloxy)ethyl phthalate, β-carboxyethyl (meth)acrylate, mono(2-((meth)acryloyloxy)ethyl) succinate, mono(2-((meth)acryloyloxy)ethyl) hexahydrophthalate, mono(2-((meth)acryloyloxy)ethyl) phthalate, neopentyl glycol benzoate (meth)acrylate, dimethylaminoethyl (meth)acrylate, diethylaminoethyl (meth)acrylate, 7-amino-3,7-dimethyloctyl (meth)acrylate, isopropyl(meth)acrylamide, tert-octyl(meth)acrylamide, isobutoxymethyl(meth)acrylamide, diacetone(meth)acrylamide, 2-hydroxyethyl(meth)acrylamide, 3-(N,N-dimethylamino)propyl(meth)acrylamide, N,N-dimethyl(meth)acrylamide, N,N-diethyl(meth)acrylamide, and (meth)acryloylmorpholine.

As the monofunctional compound, a commercially available product can be suitably used. Examples thereof include HEA, HPA, 4-HBA, AIB, TBA, NOAA, IOAA, INAA, LA, STA, ISTA, IBXA, MEDOL-10, OXE-10, OXE-30, Viscoat #150, Viscoat #150D, Viscoat #155, Viscoat #160, and Viscoat #190D [all of the above are manufactured by Osaka Organic Chemical Industry Ltd.]; LIGHT ESTER E, LIGHT ESTER NB, LIGHT ESTER IB, LIGHT ESTER TB, LIGHT ESTER EH, LIGHT ESTER ID, LIGHT ESTER L, LIGHT ESTER L-7, LIGHT ESTER S, LIGHT ESTER CH, LIGHT ESTER THF(1000), LIGHT ESTER BZ, LIGHT ESTER IB-X, LIGHT ESTER HO-250(N), LIGHT ESTER HOP(N), LIGHT ESTER HOA(N), LIGHT ESTER HOP-A(N), LIGHT ESTER HOB(N), LIGHT ESTER DM, LIGHT ESTER DE, LIGHT ESTER DQ-100, LIGHT ESTER HO-MS(N), LIGHT ESTER HO-HH(N), LIGHT ESTER G, LIGHT ESTER P-1M, LIGHT ESTER P-2M, LIGHT ACRYLATE IAA, LIGHT ACRYLATE L-A, LIGHT ACRYLATE S-A, LIGHT ACRYLATE THF-A, LIGHT ACRYLATE IB-XA, LIGHT ACRYLATE HOB-A, LIGHT ACRYLATE HOA-HH(N), LIGHT ACRYLATE BA-104, LIGHT ACRYLATE P-1A(N), EPOXY ESTER M-600A, HOA-MS(N), HOA-MPL(N), and HOA-MPE(N) [all of the above are manufactured by KYOEISHA CHEMICAL Co., LTD.]; DMAA (registered trademark), ACMO (registered trademark), NIPAM (registered trademark), DEAA (registered trademark), DMAPAA (registered trademark), and HEAA (registered trademark) [all of the above are manufactured by KJ CHEMICALS CORPORATION]; NK Ester A-SA, NK Ester S-1800A, NK Ester CB-1, NK Ester S, and NK Ester SA [all of the above are manufactured by Shin-Nakamura Chemical Co., Ltd.]; β-CEA, IBOA-B, and ODA-N [all of the above are manufactured by DAICEL-ALLNEX LTD.]; and BLEMMER (registered trademark) CHA, BLEMMER TBCHA, BLEMMER LA, BLEMMER CA, BLEMMER SA, BLEMMER VA, BLEMMER G, BLEMMER GH, BLEMMER GS, BLEMMER GLM, BLEMMER GLM-R, BLEMMER G-FA80, BLEMMER QA, BLEMMER CHMA, BLEMMER EHMA-25, BLEMMER TBCHMA, BLEMMER DMA, BLEMMER LMA, BLEMMER SLMA-S, BLEMMER SLMA-SH, BLEMMER CMA, BLEMMER SMA, BLEMMER VMA, and BLEMMER VMA-70 [all of the above are manufactured by NOF CORPORATION].

### (2) Bifunctional (having two (meth)acryloyl groups) compound

Examples of a compound having two (meth)acryloyl groups include ethylene glycol di(meth)acrylate, 1,4-butanediol di(meth)acrylate, neopentyl glycol di(meth)acrylate, 1,6-hexanediol di(meth)acrylate, 3-methyl-1,5-pentanediol di(meth)acrylate, 1,9-nonanediol di(meth)acrylate, 1,10-decanediol di(meth)acrylate, 2-methyl-1,8-octanediol di(meth)acrylate, tricyclo[5.2.1.0^{2,6}]decanedimethanol di(meth)acrylate, bisphenol A diglycidyl ether acrylic acid adduct, hydroxypivalic acid neopentyl glycol acrylic acid adduct, glycerol di(meth)acrylate, and 2-hydroxy-3-acryloyloxypropyl methacrylate.

As the bifunctional compound, a commercially available product can be suitably used. Examples thereof include Viscoat #195, Viscoat #230, Viscoat #230D, Viscoat #260, and Viscoat #540 [all of the above are manufactured by Osaka Organic Chemical Industry Ltd.]; LIGHT ACRYLATE NP-A, LIGHT ACRYLATE MPD-A, LIGHT ACRYLATE 1.6HX-A, LIGHT ACRYLATE 1.9ND-A, LIGHT ACRYLATE MOD-A, LIGHT ACRYLATE DCP-A, LIGHT ACRYLATE HPP-A, LIGHT ACRYLATE G-201P, LIGHT ESTER P-2M, LIGHT ESTER EG, LIGHT ESTER 1.4BG, LIGHT ESTER NP, LIGHT ESTER 1.6HX, LIGHT ESTER 1.9ND, LIGHT ESTER G-101P, and LIGHT ESTER G-201P [all of the above are manufactured by KYOEISHA CHEMICAL Co., LTD.]; NK Ester 701A, NK Ester A-DCP, NK Ester A-DOD-N, NK Ester A-HD-N, NK Ester A-NOD-N, NK Ester 1G, NK Ester DCP, NK Ester DOD-N, NK Ester HD-N, NK Ester NOD-N, NK Ester NPG, and NK Ester 701 [all of the above are manufactured by Shin-Nakamura Chemical Co., Ltd.]; HDDA, IRR214-K, and HPNDA [all of the above are manufactured by DAICEL-ALLNEX LTD.]; BLEMMER (registered trademark) GAM, BLEMMER GAM-R, BLEMMER GMR-H, BLEMMER GMR-R, and BLEMMER NDMA [all of the above are manufactured by NOF CORPORATION].

### (3) Trifunctional (having three (meth)acryloyl groups) compound

Examples of a compound having three (meth)acryloyl groups include 1,1,1-trimethylolethane tri(meth)acrylate, trimethylolpropane tri(meth)acrylate, ditrimethylolpropane tri(meth)acrylate, pentaerythritol tri(meth)acrylate, and glycerol tri(meth)acrylate.

As the trifunctional compound, a commercially available product can be suitably used. Examples thereof include Viscoat #295 and Viscoat #300 [all of the above are manufactured by Osaka Organic Chemical Industry Ltd.]; LIGHT ACRYLATE TMP-A, LIGHT ACRYLATE PE-3A, and LIGHT ESTER TMP [all of the above are manufactured by KYOEISHA CHEMICAL Co.,LTD]; NK Ester A-9300, NK Ester A-9300-1CL, NK Ester A-TMM-3, NK Ester A-TMM-3L, NK Ester A-TMM-3LM-N, NK Ester A-TMPT, and NK Ester TMPT [all of the above are manufactured by Shin-Nakamura Chemical Co., Ltd.]; and PETIA, PETRA, TMPTA, and EBECRYL (registered trademark) 180 [all of the above are manufactured by DAICEL-ALLNEX LTD.].

### (4) Tetrafunctional (having four (meth)acryloyl groups) compound

Examples of a compound having four (meth)acryloyl groups include ditrimethylolpropane tetra(meth)acrylate and pentaerythritol tetra(meth)acrylate.

As the tetrafunctional compound, a commercially available product can be suitably used. Examples thereof include Viscoat #300 [manufactured by Osaka Organic Chemical Industry Ltd.]; LIGHT ACRYLATE PE-4A [manufactured by KYOEISHA CHEMICAL Co.,LTD]; NK Ester AD-TMP and NK Ester A-TMMT [all of the above are manufactured by Shin-Nakamura Chemical Co., Ltd.]; and EBECRYL (registered trademark) 140, EBECRYL 1142, and EBECRYL 180 [all of the above are manufactured by DAICEL-ALLNEX LTD.].

### (5) Penta- or more functional (having five or more (meth)acryloyl groups) compound

Examples of a compound having five or more (meth)acryloyl groups include dipentaerythritol penta(meth)acrylate, dipentaerythritol hexa(meth)acrylate, and tripentaerythritol octa(meth)acrylate.

As the penta- or more functional compound, a commercially available product can be suitably used. Examples thereof include Viscoat #802 [manufactured by Osaka Organic Chemical Industry Ltd.]; LIGHT ACRYLATE DPE-6A [manufactured by KYOEISHA CHEMICAL Co.,LTD]; NK Ester A-9550 and NK Ester A-DPH [all of the above are manufactured by Shin-Nakamura Chemical Co., Ltd.]; and DPHA [manufactured by DAICEL-ALLNEX LTD.].

The amount of the polymerizable compound having a (meth)acryloyl group and having at least one structure selected from the group consisting of an oxyalkylene structure and a poly(meth)acrylic structure (c) added in the primer of the present invention is preferably 0.1 part by mass to
500 parts by mass, more preferably 1 part by mass to 200 parts by mass, and even more preferably 1 part by mass to 100 parts by mass with respect to 100 parts by mass of the complex formed of a hyperbranched polymer and metal fine particles.

### <(d) Photopolymerization Initiator>

As the photopolymerization initiator for use in the primer of the present invention, a known one may be used. Examples thereof include alkylphenones, benzophenones, acylphosphine oxides, Michler's benzoyl benzoates, oxime esters, tetramethylthiuram monosulfides, and thioxanthones.

In particular, photocleavage-type photo radical polymerization initiators are preferred. Examples of the photocleavage-type photo radical polymerization initiator include those described in "The Latest UV Curing Technique" (page 159; Publisher: Kazuhiro Takausu; Publishing company: Technical Information Institute Co. Ltd.; published in 1991).

Examples of the commercially available photo radical polymerization initiator include IRGACURE (registered trademark) 184, IRGACURE 369, IRGACURE 651, IRGACURE 500, IRGACURE 819, IRGACURE 907, IRGACURE 784, IRGACURE 2959, IRGACURE CGI1700, IRGACURE CGI1750, IRGACURE CGI1850, IRGACURE CG24-61, IRGACURE TPO, IRGACURE OXE-01, IRGACURE OXE-02, Darocur (registered trademark) 1116, and Darocur 1173 [all of the above are manufactured by BASF Japan Ltd.], and ESACURE KIP150, ESACURE KIP65LT, ESACURE KIP100F, ESACURE KT37, ESACURE KT55, ESACURE KTO46, and ESACURE KIP75 [all of the above are manufactured by Lamberti S.p.A.]. These polymerization initiators may be used in combination.

The photopolymerization initiators may be used singly or two or more kinds may be mixed. The amount of the photopolymerization initiator added is 0.01 part by mass to 20 parts by mass, and further preferably 0.1 part by mass to 10 parts by mass with respect to 100 parts by mass of the polymerizable compound (c).

### <Primer>

The primer of the present invention includes the hyperbranched polymer having an ammonium group at a molecular terminal (a), the metal fine particles (b), the polymerizable compound (c), and the photopolymerization initiator (d). Here, it is preferable that the hyperbranched polymer and the metal fine particles form a complex.

As used herein, the term "complex" means a state in which the hyperbranched polymer coexists with the metal fine particles so as to be in contact with or in proximity to the metal fine particles through the action of the ammonium group at the terminal of the hyperbranched polymer to form a particulate form. In other words, the complex has a structure in which the ammonium group of the hyperbranched polymer is attached to or coordinates with the metal fine particles.

Accordingly, the "complex" in the present invention includes a complex in which the metal fine particles and the hyperbranched polymer are bonded to form a complex as well as a complex in which the metal fine particles and the hyperbranched polymer exist independently without forming bonds.

The formation of a complex of the hyperbranched polymer having an ammonium group and the metal fine particles is performed concurrently with the preparation of the primer including the hyperbranched polymer and the metal fine particles. Examples of the method include a method in which metal fine particles stabilized to a certain degree with a lower ammonium ligand are manufactured and the ligand is exchanged with the hyperbranched polymer, and a method in which a metal ion is directly reduced in a solution of the hyperbranched polymer having an ammonium group to form a complex. For example, an aqueous solution of a metal salt is added to a solution in which the hyperbranched polymer is dissolved, and the resultant mixture is irradiated with ultraviolet light. Alternatively, an aqueous solution of a metal salt and a reducing agent are added to the hyperbranched polymer solution to reduce the metal ion to form a complex.

In the ligand exchange method, the raw material that is metal fine particles stabilized to a certain degree with a lower ammonium ligand can be manufactured, for example, by the method described in Journal of Organometallic Chemistry 1996, 520, 143-162. A hyperbranched polymer having an ammonium group is dissolved in the resultant reaction mixed solution of the metal fine particles, and the mixture is stirred at room temperature (approximately 25°C) or stirred with heating to obtain the intended metal fine particle complex.

Any solvent may be used as long as the solvent is capable of dissolving the metal fine particles and the hyperbranched polymer having an ammonium group at the necessary concentrations or higher. Specific examples thereof include alcohols such as ethanol, n-propanol, and 2-propanol; halogenated hydrocarbons such as methylene chloride and chloroform; cyclic ethers such as tetrahydrofuran (THF), 2-methyltetrahydrofuran, and tetrahydropyran; nitriles such as acetonitrile and butyronitrile, and a mixture of these solvents. Preferably, tetrahydrofuran is used.

The temperature at which the reaction mixture of the metal fine particles and the hyperbranched polymer having an ammonium group are mixed may be generally from 0°C to the boiling point of the solvent, and preferably in a range of room temperature (approximately 25°C) to 60°C.

In the ligand exchange method, a phosphine dispersant (phosphine ligand) may be used instead of the amine dispersant (lower ammonium ligand) to stabilize metal fine particles to a certain degree beforehand.

In the direct reduction method, a metal ion and a hyperbranched polymer having an ammonium group are dissolved in a solvent, and reduction is performed with a primary or secondary alcohol such as methanol, ethanol, 2-propanol, and polyols to obtain the intended metal fine particle complex.

The source of the metal ion used includes the above-noted metal salts.

Any solvent may be used as long as the solvent is capable of dissolving the metal ion and the hyperbranched polymer having an ammonium group to the necessary concentrations or higher. Specific examples thereof include alcohols such as methanol, ethanol, propanol, and 2-propanol; halogenated hydrocarbons such as methylene chloride and chloroform; cyclic ethers such as tetrahydrofuran (THF), 2-methyltetrahydrofuran, and tetrahydropyran; nitriles such as acetonitrile and butyronitrile; amides such as N,N-dimethylformamide (DMF) and N-methyl-2-pyrrolidone (NMP); sulfoxides such as dimethylsulfoxide, and a mixture of these solvents. Preferably, alcohols, halogenated hydrocarbons, and cyclic ethers are used. More preferably, ethanol, 2-propanol, chloroform, and tetrahydrofuran, are used.

The temperature for the reduction reaction can be generally from 0°C to the boiling point of the solvent, preferably in a range of room temperature (approximately 25°C) to 60°C.

As another direct reduction method, a metal ion and a hyperbranched polymer having an ammonium group are dissolved in a solvent and allowed to react under a hydrogen atmosphere to obtain the intended metal fine particle complex.

The source of the metal ion used includes the above-noted metal salts and metal carbonyl complexes such as hexacarbonylchromium [Cr(CO)₆], pentacarbonyliron [Fe(CO)₅], octacarbonyldicobalt [CO₂(CO)₈], and tetracarbonylnickel [Ni(CO)₄]. Zero-valent metal complexes such as metal olefin complexes, metal phosphine complexes, and metal nitrogen complexes may also be used.

Any solvent may be used as long as the solvent is capable of dissolving the metal ion and the hyperbranched polymer having an ammonium group to the necessary concentrations or higher. Specific examples thereof include alcohols such as ethanol and propanol; halogenated hydrocarbons such as methylene chloride and chloroform; cyclic ethers such as tetrahydrofuran, 2-methyltetrahydrofuran, and tetrahydropyran; nitriles such as acetonitrile and butyronitrile, and a mixture of these solvents. Preferably, tetrahydrofuran is used.

The temperature at which the metal ion and the hyperbranched polymer having an ammonium group are mixed may be generally from 0°C to the boiling point of the solvent.

As the direct reduction method, a metal ion and a hyperbranched polymer having an ammonium group may be dissolved in a solvent and subjected to thermal decomposition to obtain the intended metal fine particle complex.

The source of the metal ion used includes the above-noted metal salts, metal complexes such as metal carbonyl complexes and other zero-valent metal complexes, and metal oxides such as silver oxide.

Any solvent may be used as long as the solvent is capable of dissolving the metal ion and the hyperbranched polymer having an ammonium group to the necessary concentrations or higher. Specific examples thereof include alcohols such as methanol, ethanol, n-propanol, 2-propanol, and ethylene glycol; halogenated hydrocarbons such as methylene chloride and chloroform; cyclic ethers such as tetrahydrofuran (THF), 2-methyltetrahydrofuran, and tetrahydropyran; nitriles such as acetonitrile and butyronitrile; aromatic hydrocarbons such as benzene and toluene, and a mixture of these solvents. Preferably, toluene is used.

The temperature at which the metal ion and the hyperbranched polymer having an ammonium group are mixed may be generally from 0°C to the boiling point of the solvent. The temperature is preferably close to the boiling point of the solvent, for example, 110°C (heating at reflux) in the case of toluene.

The complex of the hyperbranched polymer having an ammonium group and the metal fine particles thus obtained can be formed as a solid such as powder after purification such as reprecipitation.

The primer of the present invention includes the hyperbranched polymer having an ammonium group (a) and the metal fine particles (b) (preferably, a complex formed thereof), the polymerizable compound (c) and the photopolymerization initiator (d), and may be in the form of varnish that is used for forming the [priming layer for electroless plating] as described later.

### <Thickener>

The primer of the present invention may contain a thickener as necessary to adjust the viscosity or the rheology characteristic of the primer. Thus, the addition of the thickener plays an important role particularly when the primer of the present invention is used as print ink.

Examples of the thickener include poly(acrylic acid)s (including cross-linked ones) such as carboxyvinyl polymer (carbomer); vinyl polymers such as poly(vinyl pyrrolidone) (PVP), poly(vinyl alcohol) (PVA), poly(vinyl acetate) (PVAc), and polystyrene (PS); poly(ethylene oxide)s; polyesters; polycarbonates; polyamides; polyurethanes; polysaccharides such as dextrin, agar, carrageenan, alginic acid, gum arabic, guar gum, tragacanth gum, locust bean gum, starch, pectin, carboxymethyl cellulose, hydroxyethyl cellulose, and hydroxypropyl cellulose; and proteins such as gelatin and casein. The above-noted polymers include not only homopolymers but also copolymers. These thickeners may be used singly or may be used in combination of two or more.

### <Other Additives>

The primer of the present invention may further appropriately contain additives such as a surfactant, various kinds of surface conditioners, and a defoamer as long as the effect of the present invention is not impaired.

Examples of the surfactant include polyoxyethylene alkyl ethers such as polyoxyethylene lauryl ether, polyoxyethylene stearyl ether, polyoxyethylene cetyl ether, and polyoxyethylene oleyl ether; polyoxyethylene alkylaryl ethers such as polyoxyethylene octylphenyl ether and polyoxyethylene nonylphenyl ether; polyoxyethylene-polyoxypropylene block copolymers; sorbitan fatty acid esters such as sorbitan monolaurate, sorbitan monopalmitate, sorbitan monostearate, sorbitan monooleate, sorbitan tristearate, and sorbitan trioleate; polyoxyethylene nonionic surfactants such as polyoxyethylene sorbitan monolaurate, polyoxyethylene sorbitan monopalmitate, polyoxyethylene sorbitan monostearate, and polyoxyethylene sorbitan trioleate; and fluorine-based surfactants such as EFTOP (registered trademark) EF-301, EFTOP EF-303, and EFTOP EF-352 [all of the above are manufactured by Mitsubishi Materials Electronic Chemicals Co., Ltd.], MEGAFACE (registered trademark) F-171, MEGAFACE F-173, MEGAFACE R-08, and MEGAFACE R-30 [all of the above are manufactured by DIC Corporation], Novec (registered trademark) FC-430 and Novec FC-431 [all of the above are manufactured by Sumitomo 3M Ltd.], ASAHI GUARD (registered trademark) AG-710 [manufactured by Asahi Glass Co., Ltd.], and SURFLON (registered trademark) S-382 [manufactured by AGC Seimi Chemical Co., Ltd.].

Examples of the surface conditioner include silicone-based leveling agents such as Shin-Etsu Silicone (registered trademark) KP-341 [manufacture by Shin-Etsu Chemical Co., Ltd.]; and silicone-based surface conditioners such as BYK (registered trademark)-302, BYK-307, BYK-322, BYK-323, BYK-330, BYK-333, BYK-370, BYK-375, and BYK-378 [manufactured by BYK Japan KK].

These additives may be used singly or may be used in combination of two or more. The additives are used in an amount of preferably 0.001 part by mass to 50 parts by mass, more preferably 0.005 part by mass to 10 parts by mass, and even more preferably 0.01 part by mass to 5 parts by mass with respect to 100 parts by mass of the complex formed of the hyperbranched polymer and the metal fine particles.

### [Priming Layer for Electroless Plating]

The primer of the present invention may be applied on a base material and photocured to form a priming layer for electroless plating. The present invention is also directed to the priming layer for electroless plating.

The base material is not limited, and a nonconducting base material or a conducting base material may be preferably used.

Examples of the nonconducting base material include glass, ceramics; polyethylene resins, polypropylene resins, vinyl chloride resins, nylons (polyamide resins), polyimide resins, polycarbonate resins, acrylic resins, PEN (poly(ethylene naphthalate)) resins, PET (poly(ethylene terephthalate)) resins, PEEK (poly(ether ether ketone)) resins, ABS (acrylonitrile-butadiene-styrene copolymer) resins, epoxy resins, and polyacetal resins; and paper. The nonconducting base material is suitably used in the form of sheet, film, or the like, and in these cases, the thickness is not limited.

Examples of the conducting base material include ITO (tin-doped indium oxide), ATO (antimony-doped tin oxide), FTO (fluorine-doped tin oxide), AZO (aluminum-doped zinc oxide), and GZO (gallium-doped zinc oxide), and metals such as various stainless steels, aluminum and aluminum alloys such as duralumin, iron and iron alloys, copper and copper alloys such as brass, phosphor bronze, cupronickel, and beryllium copper, nickel and nickel alloys, and silver and silver alloys such as nickel silver.

Furthermore, a base material in which a thin film of any of these conducting base materials is formed on the nonconducting base material is also usable.

The base material may also be a three-dimensionally formed body.

The specific method to form a priming layer for electroless plating from the primer containing the hyperbranched polymer having an ammonium group, the metal fine particles, the polymerizable compound, and the photopolymerization initiator is as follows. First, the hyperbranched polymer having an ammonium group, the metal fine particles (preferably a complex formed thereof), the polymerizable compound, and the photopolymerization initiator are dissolved or dispersed in a suitable solvent to form a varnish. The varnish is applied on a base material on which a metal plating coating film is to be formed, for example, by spin coating; blade coating; dip coating; roll coating; bar coating; die coating; spray coating; ink jet method; pen lithography such as fountain-pen nanolithography (FPN) and dip-pen nanolithography (DPN); relief printing such as letterpress printing, flexography, resin relief printing, contact printing, microcontact printing (µCP), nanoimprinting lithography (NIL), and nanotransfer printing (nTP); intaglio printing such as gravure printing and engraving; planographic printing; stencil printing such as screen printing and mimeograph; or offset printing. Thereafter, preferably subsequently, the solvent is evaporated and dried, and then photocured by radiating active light such as ultraviolet rays to form a thin layer.

Among these application methods, spin coating, spray coating, ink jet method, pen lithography, contact printing, µCP, NIL, and nTP are preferred. Spin coating has advantages in that a highly volatile solution can be used because the application requires a short time and that a highly uniform coating can be obtained. Spray coating needs only a very small amount of vanish to obtain a highly uniform coating, which is industrially very advantageous. Ink jet method, pen lithography, contact printing, µCP, NIL, and nTP can form (draw), for example, fine patterns such as wiring efficiently, which is industrially very advantageous.

Any solvent can be used as long as the solvent dissolves or disperses the complex, the polymerizable compound, and the photosensitive initiator. Examples thereof include water; aromatic hydrocarbons such as benzene, toluene, xylene, ethylbenzene, chlorobenzene, and dichlorobenzene; alcohols such as methanol, ethanol, n-propanol, 2-propanol, n-butanol, 2-butanol, n-hexanol, n-octanol, 2-octanol, and 2-ethylhexanol; cellosolves such as methyl cellosolve, ethyl cellosolve, butyl cellosolve, and phenyl cellosolve; glycol ethers such as propylene glycol monomethyl ether (PGME), propylene glycol monoethyl ether, propylene glycol monobutyl ether, diethylene glycol monomethyl ether, diethylene glycol monobutyl ether, dipropylene glycol monomethyl ether, triethylene glycol monomethyl ether, tripropylene glycol monomethyl ether, ethylene glycol dimethyl ether, propylene glycol dimethyl ether, diethylene glycol dimethyl ether, diethylene glycol diethyl ether, diethylene glycol dibutyl ether, diethylene glycol ethyl methyl ether, diethylene glycol butyl methyl ether, diethylene glycol isopropyl methyl ether, dipropylene glycol dimethyl ether, triethylene glycol dimethyl ether, and tripropylene glycol dimethyl ether; glycol esters such as ethylene glycol monomethyl ether acetate, and propylene glycol monomethyl ether acetate (PGMEA); ethers such as tetrahydrofuran (THF), methyltetrahydrofuran, 1,4-dioxane, and diethyl ether; esters such as ethyl acetate and butyl acetate; ketones such as acetone, methyl ethyl ketone (MEK), methyl isobutyl ketone (MIBK), cyclopentanone, and cyclohexanone; aliphatic hydrocarbons such as n-heptane, n-hexane, and cyclohexane; halogenated aliphatic hydrocarbons such as 1,2-dichloroethane and chloroform; amides such as N-methyl-2-pyrrolidone (NMP), N,N-dimethylformamide (DMF), and N,N-dimethylacetamide; and dimethyl sulfoxide. These solvents may be used singly, or two or more solvents may be mixed. Glycols such as ethylene glycol, propylene glycol, and butylene glycol may be added to adjust the viscosity of the varnish.

The complex, the polymerizable compound, and the photosensitive initiator are dissolved or dispersed in the solvent at any concentration. The concentration of the complex in the varnish is 0.05% by mass to 90% by mass, preferably 0.1% by mass to 80% by mass.

The solvent for use in the ink jet method is preferably a mixed solvent composed of water, monoalcohol, and polyalcohol.

### <Monoalcohol>

Examples of the monoalcohol include lower alcohols such as methanol, ethanol, 1-propanol, 2-propanol, 1-butanol, 2-butanol, 2-methylpropanol, 2-methyl-2-propanol, and 2-ethylhexanol; ethylene glycol monoalkyl ethers (cellosolves) such as ethylene glycol monomethyl ether (methyl cellosolve), ethylene glycol monoethyl ether (ethyl cellosolve), ethylene glycol monopropyl ether (propyl cellosolve), ethylene glycol monoisopropyl ether (isopropyl cellosolve), ethylene glycol monobutyl ether (butyl cellosolve), and ethylene glycol monophenyl ether (phenyl cellosolve); propylene glycol monoalkyl ethers such as propylene glycol monomethyl ether (PGME), propylene glycol monoethyl ether, propylene glycol monopropyl ether, propylene glycol monobutyl ether, and propylene glycol monophenyl ether; other alkoxy alcohols such as 3-methoxypropanol, 3-ethoxypropanol, 3-propoxypropanol, 3-butoxypropanol, 3-methoxybutanol, 3-methoxy-3-methylbutanol, and 4-methoxybutanol; diacetone alcohol; and lactic acid esters such as methyl lactate and ethyl lactate. These monoalcohols may be used singly or in combination of two or more.

Among these, lower alcohols and diacetone alcohol are preferable, and 1-propanol and diacetone alcohol are more preferable.

### <Polyalcohol>

Examples of the polyalcohol include ethylene glycol; propanediols such as 1,2-propanediol (propylene glycol), 1,3-propanediol, and 2-methyl-1,3-propanediol; butanediols such as 1,2-butanediol, 1,3-butanediol, 1,4-butanediol, 2,3-butanediol, and 2-methyl-1,4-butanediol; pentanediols such as 1,5-pentanediol, 3-methyl-1,5-pentanediol, and 2-methyl-2,4-pentanediol; hexanediols such as 1,6-hexanediol; triols such as glycerol and 1,2,6-hexanetriol. These polyalcohols may be used singly or in combination of two or more.

Among these, propanediols and butanediols are preferable, and 1,2-propanediol (propylene glycol), 1,3-propanediol, 1,3-butanediol, and 1,4-butanediol are more preferable.

Examples of a preferable combination thereof include water/1-propanol/ethylene glycol, water/1-propanol/1,2-propanediol (propylene glycol), water/1-propanol/1,3-propanediol, water/1-propanol/1,3-butanediol, water/1-propanol/1,4-butanediol, water/1-propanol/2,3-butanediol, water/1-propanol/1,6-hexanediol, water/diacetone alcohol/ethylene glycol, water/diacetone alcohol/1,2-propanediol (propylene glycol), water/diacetone alcohol/2-ethylhexanol/ethylene glycol monophenyl ether (phenyl cellosolve)/1,2-propanediol (propylene glycol), water/diacetone alcohol/1,3-propanediol, water/diacetone alcohol/1,3-butanediol, water/diacetone alcohol/1,4-butanediol, water/diacetone alcohol/2,3-butanediol, water/methanol/1,2-propanediol (propylene glycol), water/ethanol/1,2-propanediol (propylene glycol), water/2-propanol/1,2-propanediol (propylene glycol), water/1-butanol/1,2-propanediol (propylene glycol), water/2-butanol/1,2-propanediol (propylene glycol), water/2-methylpropanol/1,2-propanediol (propylene glycol), and water/2-methyl-2-propanol/1,2-propanediol (propylene glycol).

Among these, water/1-propanol/1,2-propanediol (propylene glycol), water/1-propanol/1,3-propanediol, water/1-propanol/1,3-butanediol, water/1-propanol/1,4-butanediol, water/diacetone alcohol/ethylene glycol, water/diacetone alcohol/1,2-propanediol (propylene glycol), water/diacetone alcohol/2-ethylhexanol/ethylene glycol monophenyl ether (phenyl cellosolve)/1,2-propanediol (propylene glycol), water/diacetone alcohol/1,3-propanediol, water/diacetone alcohol/1,3-butanediol, and water/diacetone alcohol/1,4-butanediol are more preferable.

The proportion of monoalcohol in the mixed solvent is preferably 5% by mass or higher and lower than 80% by mass, 10% by mass or higher and lower than 80% by mass, 20% by mass or higher and lower than 70% by mass, 5% by mass or higher and lower than 50% by mass, or 20% by mass or higher and lower than 40% by mass.

The proportion of polyalcohol in the mixed solvent is preferably 5% by mass or higher and lower than 50% by mass, and more preferably 20% by mass or higher and lower than 40% by mass.

The concentration of the complex dissolved or dispersed in the mix solvent is not limited. The concentration of the complex in the varnish is 0.05% by mass to 10% by mass, and preferably 0.1% by mass to 5% by mass.

If the concentration of the complex is lower than 0.05% by mass, disconnection of wiring is likely to occur when the catalyst ink is applied by inkjet. If the concentration of the complex exceeds 10% by mass, there is a risk that clogging of the ink jet nozzle may occur.

The method for drying the solvent is not limited. For example, a hotplate or an oven can be used to evaporate the solvent under an appropriate atmosphere, that is, air, inert gas such as nitrogen, or in vacuum. This can provide a priming layer having a uniformly formed film surface. The baking temperature is not limited as long as the solvent can be evaporated, and a temperature of 40°C to 250°C is preferably used.

Examples of the active light for use in photopolymerization include ultraviolet rays, electron beams, and X rays. Examples of the light source for use in ultraviolet radiation include sunlight, chemical lamps, low-pressure mercury lamps, high-pressure mercury lamps, metal halide lamps, xenon lamps, and UV-LEDs. After photopolymerization, post-bake is performed if necessary, specifically, heating is performed with a hot plate, or oven, to complete polymerization. Post-bake is performed generally, but not limited to, in a range of 50°C to 260°C for 1 minute to 120 minutes.

### [Electroless Plating Process, Metal Plating Film, Metal-Coated Base Material]

The priming layer for electroless plating formed on the base material thus obtained is subjected to electroless plating to form a metal plating film on the priming layer for electroless plating. The present invention is also directed to the metal plating film thus obtained as well as the metal-coated base material having a priming layer for electroless plating and a metal plating film in this order on a base material.

The electroless plating process (step) is not limited, and any commonly known electroless plating process may be used. For example, the common method involves using a conventionally known electroless plating solution and immersing a priming layer for electroless plating formed on the base material in the plating solution (bath).

The electroless plating solution mainly contains a metal ion (a metal salt), a complexing agent, and a reducing agent. Depending on the application, a pH adjusting agent, a pH buffering agent, a reaction accelerator (a second complexing agent), a stabilizer, a surfactant (used for, for example, giving a luster to the plating film and improving wettability of the surface to be treated), and other agents are contained as appropriate.

Examples of the metal for use for the metal plating film formed by electroless plating include iron, cobalt, nickel, copper, palladium, silver, tin, platinum, gold, and alloys thereof. The metal is appropriately selected depending on the purpose.

The complexing agent and the reducing agent may be appropriately selected depending on the metal ion.

The electroless plating solution may be a commercially available plating solution. Preferable examples thereof include electroless nickel plating agents (Melplate (registered trademark) NI series) and electroless copper plating agents (Melplate (registered trademark) CU series) manufactured by Meltex Inc.; electroless nickel plating solutions (ICP Nicoron (registered trademark) series, Top Piena 650), electroless copper plating solutions (OPC-700 electroless copper M-K, ATS Addcopper IW, ATS Addcopper CT, OPC Copper (registered trademark) AF series, OPC Copper HFS, and OPC Copper NCA), an electroless tin plating solution (Substar SN-5), and electroless gold plating solutions (Flash Gold 330, and Self Gold OTK-IT), an electroless silver plating solution (MUDEN SILVER) manufactured by Okuno Chemical Industries Co., Ltd.; an electroless palladium plating solution (Pallet II) and electroless gold plating solutions (Dip G series, NC Gold series) manufactured by Kojima Chemicals Co., Ltd.; an electroless silver plating solution (S-DIA AG-40) manufactured by SASAKI CHEMICAL CO., LTD.; electroless nickel plating solutions (SUMER (registered trademark) series, and KANIBLACK (registered trademark) series), and an electroless palladium plating solution (S-KPD) manufactured by JAPAN KANIGEN CO., LTD.; electroless copper plating solutions (CUPOSIT (registered trademark) COPPER MIX series, and CIRCUPOSIT (registered trademark) series), electroless palladium plating solutions (PALLAMERSE (registered trademark) series), electroless nickel plating solutions (DURAPOSIT (registered trademark) series), electroless gold plating solutions (AUROLECTROLESS (registered trademark) series), and electroless tin plating solutions (TINPOSIT (registered trademark) series) manufactured by The Dow Chemical Company; electroless copper plating solutions (THRU-CUP (registered trademark) ELC-SP, THRU-CUP PSY, THRU-CUP PCY, THRU-CUP PGT, THRU-CUP PSR, THRU-CUP PEA, and THRU-CUP PMK) manufactured by C. Uyemura & Co., Ltd.; and electroless copper plating solutions (Printganth (registered trademark) PV, and Printganth PVE) manufactured by Atotech Japan K.K.

In the electroless plating process, plating bath temperature, pH, immersion time, concentration of metal ion, presence or absence of stirring and stirring speed, presence or absence of feeding of air or oxygen and feeding speed, and other conditions may be adjusted to control the forming speed of a metal coating film and the thickness of the film.

### Examples

The present invention will be described more specifically with reference to Examples, which are not intended to limit the present invention. In Examples, physical properties of the samples were measured by using the following apparatuses under the following conditions.

### (1) GPC (Gel Permeation Chromatography)

Apparatus: HLC-8220GPC manufactured by Tosoh Corporation
Column: Shodex (registered trademark) GPC KF-804L + Shodex GPC KF-803L manufactured by Showa Denko K.K.
Column temperature: 40°C
Solvent: tetrahydrofuran
Detector: UV (254 nm), RI

### (2) ¹H NMR Spectrum

Apparatus: JNM-L400 manufactured by JEOL Ltd.
Solvent: CDCl₃
Reference peak: tetramethylsilane (0.00 ppm)

### (3) ¹³C NMR Spectrum

Apparatus: JNM-ECA700 manufactured by JEOL Ltd.
Solvent: CDCl₃
Relaxation reagent: chromium trisacetylacetonate (Cr(acac)₃)
Reference peak: CDCl₃ (77.0 ppm)

### (4) ICP Atomic Emission Spectroscopy (inductively coupled plasma atomic emission spectroscopy)

Apparatus: ICPM-8500 manufactured by Shimadzu Corporation

### (5) TEM (transmission electron microscope) Image

Apparatus: H-8000 manufactured by Hitachi High-Technologies Corporation

### (6) UV Radiation System

Apparatus: US5-0401 manufactured by EYE GRAPHICS CO., LTD.

### (7) Ink Jet System

Apparatus: Inkjet Designer manufactured by Cluster Technology Co., Ltd.
Driver: Wave Builder (registered trademark) PIJD-1SET manufactured by Cluster Technology Co., Ltd.
Head: Pulselnjector (registered trademark) PIJ-15NSET (nozzle diameter: 15 µm) manufactured by Cluster Technology Co., Ltd.

### (8) Digital Microscopic Image

Apparatus: VHX-2000 manufactured by Keyence Corporation

Abbreviations used are as follows.
HPS: hyperbranched polystyrene [HYPERTECH (registered trademark) HPS-200 manufactured by Nissan Chemical Industries, Ltd.]
2EH: 2-ethylhexanol
DAA: diacetone alcohol
IPA: 2-propanol
IPE: diisopropyl ether
PG: propylene glycol
PhC: phenyl cello solve
PrOH: 1-propanol
PEN: poly(ethylene naphthalate)
4EG2A: tetraethylene glycol diacrylate [BLEMMER (registered trademark) ADE-200 manufactured by NOF CORPORATION]
14EG2A: tetradecaethylene glycol diacrylate [LIGHT ACRYLATE 14EG-A manufactured by KYOEISHA CHEMICAL Co., LTD.]
DD2A: 1,10-decanediol diacrylate [NK Ester A-DOD-N manufactured by Shin-Nakamura Chemical Co., Ltd.]
DEAA: N,N-diethylacrylamide [DEAA (registered trademark) manufactured by KJ CHEMICALS CORPORATION]
DP6A-12E: ethylene oxide-modified dipentaerythritol hexaacrylate (the number of moles of ethylene oxide added: 12) [NK Ester A-DPH-12E manufactured by Shin-Nakamura Chemical Co., Ltd.]
EEEA: 2-(2-ethoxyethoxy)ethyl acrylate [Viscoat #190 manufactured by Osaka Organic Chemical Industry Ltd.]
G3A-20E: ethylene oxide-modified glycerol triacrylate (the number of moles of ethylene oxide added: 20) [NK Ester A-GLY-20E manufactured by Shin-Nakamura Chemical Co., Ltd.]
LA: lauryl acrylate [BLEMMER (registered trademark) LA manufactured by NOF CORPORATION]
P4A-4E: ethylene oxide-modified pentaerythritol tetraacrylate (the number of moles of ethylene oxide added: 4) [NK Ester ATM-4E manufactured by Shin-Nakamura Chemical Co., Ltd.]
POEA: (2-phenoxyethyl) acrylate [Viscoat #192 manufactured by Osaka Organic Chemical Industry Ltd.]
UA4200: polyether skeleton bifunctional urethane acrylate [NK Oligo UA-4200 manufactured by Shin-Nakamura Chemical Co., Ltd.]
UV7605B: hexafunctional urethane acrylate [SHIKOH (registered trademark) UV-7605B manufactured by The Nippon Synthetic Chemical Industry Co., Ltd.] 8KX: (meth)acrylic (meth)acrylate [ACRIT 8KX-078 manufactured by TAISEI FINE CHEMICAL CO., LTD.]
8UH: polyurethane (meth)acrylate [ACRIT 8UH-1006 manufactured by TAISEI FINE CHEMICAL CO., LTD.]
TPO: diphenyl(2,4,6-trimethylbenzoyl)phosphine oxide [IRGACURE (registered trademark) TPO manufactured by BASF Japan Ltd.]
NXZ: metallic soap defoamer [NOPCO (registered trademark) NXZ manufactured by San Nopco Limited]

### [Production Example 1] Production of HPS-Cl

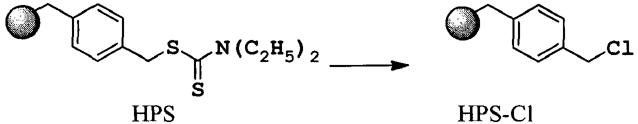

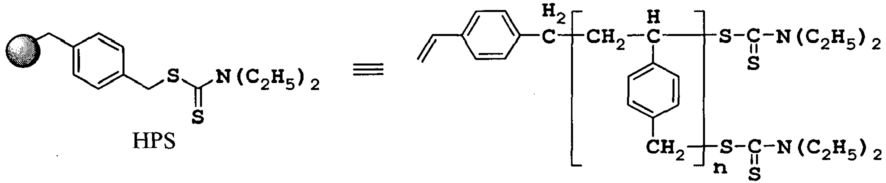

A 500-mL reaction flask was charged with 27 g of sulfuryl chloride [manufactured by KISHIDA CHEMICAL CO., LTD.] and 50 g of chloroform, and the mixture was stirred to be uniformly dissolved. This solution was cooled to 0°C in a nitrogen stream.

Another 300-mL reaction flask was charged with 15 g of a hyperbranched polymer HPS having a dithiocarbamate group at a molecular terminal and 150 g of chloroform, and the mixture was stirred in a nitrogen stream until it became uniform.

The HPS/chloroform solution was added with a feeding pump from the 300-mL reaction flask containing the HPS/chloroform solution to the sulfuryl chloride/chloroform solution cooled to 0°C in a nitrogen stream over 60 minutes so that the temperature of the reaction liquid was from -5°C to 5°C. After the addition was completed, the reaction liquid was stirred for 6 hours while the temperature was kept at -5°C to 5°C
A solution in which 16 g of cyclohexene [manufactured by Tokyo Chemical Industry Co., Ltd.] was dissolved in 50 g of chloroform was added to this reaction liquid so that the temperature of the reaction liquid became from -5°C to 5°C. After the addition was completed, this reaction liquid was added to 1,200 g of IPA to precipitate the polymer. This precipitate was filtered to obtain a white powder, which was dissolved in 100 g of chloroform. The liquid was added to 500 g of IPA to reprecipitate the polymer. This precipitate was filtered under reduced pressure and vacuum-dried to obtain 8.5 g of a hyperbranched polymer having a chlorine atom at a molecular terminal (HPS-Cl) as a white powder (yield 99%).

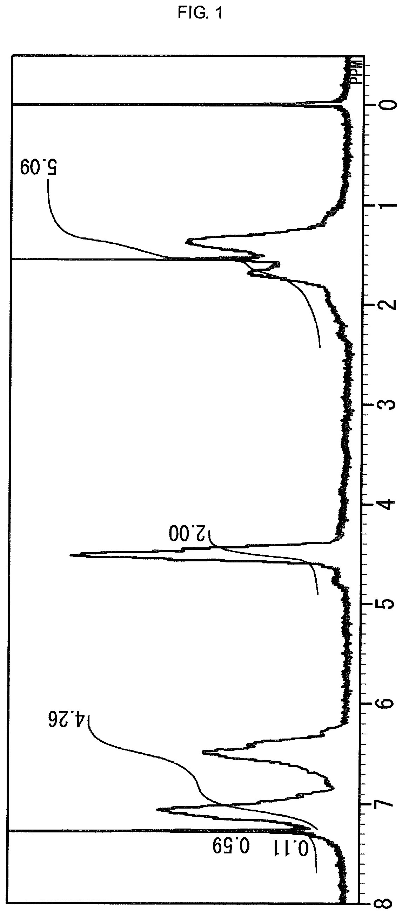

The ¹H NMR spectrum of the obtained HPS-Cl is illustrated in FIG. 1. Since the peaks derived from the dithiocarbamate group (4.0 ppm, 3.7 ppm) disappeared, it was found that almost all the dithiocarbamate groups at the molecular terminals of the HPS were replaced with chlorine atoms in the obtained HPS-Cl. The weight-average molecular weight Mw of the obtained HPS-Cl measured by GPC in terms of polystyrene was 14,000, and the degree of distribution Mw/Mn was 2.9.

### [Production Example 2] Production of HPS-N(Me)₂OctCl

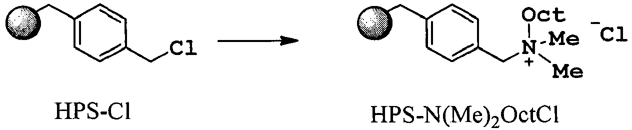

A 100-mL reaction flask equipped with a condenser was charged with 4.6 g (30 mmol) of HPS-Cl produced in Production Example 1 and 15g of chloroform, and the mixture was stirred until it became uniform. To this solution, a solution in which 5.0 g (31.5 mmol) of dimethyloctylamine [FARMIN (registered trademark) DM0898 manufactured by Kao Corporation] was dissolved in 7.5 g of chloroform was added, and 7.5 g of IPA was further added thereto. This mixture was stirred under a nitrogen atmosphere at 65°C for 40 hours.

After the mixture was cooled to a liquid temperature of 30°C, the solvent was distilled off. The resultant residue was dissolved in 60 g of chloroform, and the solution was added to 290 g of IPE for purification by reprecipitation. The precipitated polymer was filtered under reduced pressure and vacuum-dried at 50°C to obtain 9.3 g of a hyperbranched polymer having a dimethyloctylammonium group at a molecular terminal (HPS-N(Me)₂OctCl) as a white powder.

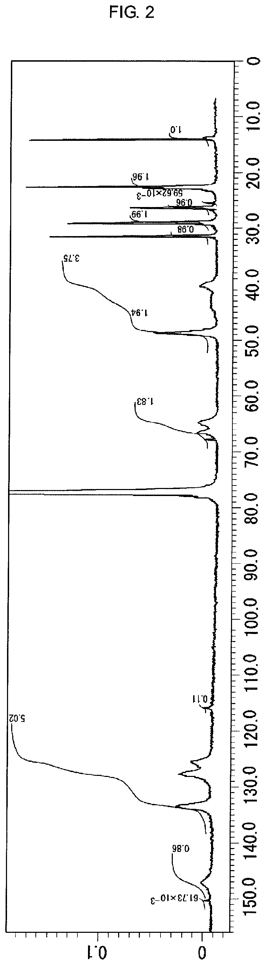

The ¹³C NMR spectrum of the obtained HPS-N(Me)₂OctCl is illustrated in FIG. 2. From the peak of the benzene ring and the peak of the methyl group of the octyl group terminal, it was found that, in the obtained HPS-N(Me)₂OctCl, the chlorine atoms at the molecular terminals of HPS-Cl were replaced with ammonium groups substantially quantitatively. The weight-average molecular weight (Mw) of HPS-N(Me)₂OctCl calculated from Mw (14,000) of HPS-Cl and the degree of introduction of ammonium group (100%) was 28,000.

### [Production Example 3] Production of Pd[HPS-N(Me)₂OctCl]

A 500-mL reaction flask equipped with a condenser was charged with 4.6 g of palladium acetate [manufactured by Kawaken Fine Chemicals Co., Ltd.] and 100 g of chloroform, and the mixture was stirred until it became uniform. To this solution, a solution in which 5.0 g of HPS-N(Me)₂OctCl produced in Production Example 2 was dissolved in 100 g of chloroform was added with a dropping funnel. The inside of the dropping funnel was washed with 100 g of chloroform and 100 g of ethanol and the resultant chloroform and ethanol were added to the reaction flask. This mixture was stirred under a nitrogen atmosphere at 60°C for 14 hours.

After the mixture was cooled to a liquid temperature of 30°C, the solvent was distilled off. The resultant residue was dissolved in a mixture of 38 g of chloroform and 38 g of ethanol, and this solution was added to 750 g of IPE for purification by reprecipitation. The precipitated polymer was filtered under reduced pressure and vacuum-dried at 50°C to obtain 7.0 g of a complex of the hyperbranched polymer having an ammonium group at a molecular terminal and Pd particles (Pd[HPS-N(Me)₂OctCl]) as a black powder.

The result of ICP atomic emission spectroscopy indicated that the Pd content of the resultant Pd[HPS-N(Me)₂OctCl] was 31% by mass. The TEM (transmission electron microscope) image indicated that the Pd particles had a particle diameter of approximately 2 nm to 4 nm.

### [Reference Example 1] Preparation of Electroless Copper Plating Solution

An electroless copper plating solution was prepared as follows using a commercially available Printganth (registered trademark) PV [manufactured by Atotech Japan K.K.].

A 200-mL flask was charged with 178 mL of pure water, 15 mL of Basic Printganth V, 2 mL of Copper Solution Printganth VE, 1.2 mL of Starter Printganth PV, 0.2 mL of Stabilizer Printganth PV, 3.2 mL of Reducer Cu, and 0.52 g of NaOH. The mixture was stirred and heated up to 40°C to obtain an electroless copper plating solution.

### [Examples 1 to 12]

The components below were mixed to prepare a primer for electroless plating including a hyperbranched polymer-Pd particle complex (HBP-Pd) at a concentration of 1% by mass.
(1) HBP-Pd: Pd[HPS-N(Me)₂OctCl], 100 parts by mass
(2) Polymerizable compound: the compound described in Table 1, the amount described in Table 1
(3) Photopolymerization initiator: TPO, 3 parts by mass relative to the polymerizable compound
(4) Solvent: water-PrOH-PG mixed solution (mass ratio of 1:1:1), the amount such that the total amount of (1) to (4) is 10,000 parts by mass

The primer was spin-coated on the easy-adhesion surface of a PEN film (50x50 mm) (200 rpm×5 seconds, followed by 2,000 rpm×30 seconds). This base material was dried on a hot plate at 80°C for 1 minute and then on a hot plate at 150°C for 5 minutes to obtain a base material having a priming layer on the entire surface of the base material. The resultant priming layer was cured by radiating UV light with exposure energy of 800 mJ/cm² under an air atmosphere for exposure.

The resultant base material was immersed in the electroless copper plating solution prepared in Reference Example 1 and heated to 40°C, for 10 minutes. Subsequently, the base material was taken out and washed with water, and dried on a hot plate at 120°C for 10 minutes to obtain a plated base material.

The untreated surface of another PEN film was plated by the method as described above to obtain a plated base material.

For each of the metal plating films on these plated base materials, the adhesion to the base material was evaluated. For the adhesion to the base material, an adhesive tape [CELLOTAPE (registered trademark) CT-18S manufactured by NICHIBAN CO., LTD.] having a width of 18 mm was affixed on the metal plating film portion on the obtained plated base material and rubbed hard with the finger to cause the adhesive tape to firmly adhere thereto. The adhering adhesion tape was removed at a time, and the state of the metal plating film was evaluated by visual inspection according to the criteria below. The results are listed in Table 1.

### <Evaluation Criteria for Adhesion to Base Material>

A: delamination of the metal plating film was not observed, and the metal plating film adhered to the base material.
B: the metal plating film was partially delaminated.
C: about 30% or more of the part of the metal plating film, to which the adhesive tape had adhered, was delaminated and attached to the adhesive tape.

### [Examples 14, 15]

The manipulation and the evaluation were conducted in the same manner as in Example 1 except that 5 parts by mass of NXZ as a defoamer (5) was blended and that the solvent (4) was changed to a water-DAA-2EH-PhC-PG mixed solution (mass ratio of 5:64:5:1:25) in an amount such that the total amount of (1) to (5) was 10,000 parts by mass. The results are listed in Table 1.

### [Comparative Example 1]

The manipulation and the evaluation were conducted in the same manner as in Example 1 except that neither the polymerizable compound nor the photopolymerization initiator was added. The results are listed in Table 1.

### [Table 1]

**Table 1**

| | HBP-Pd [parts by mass] | Polymerizable compound | | TPO [parts by mass] | Adhesion to the base material | |
|---|---|---|---|---|---|---|
| | | Kind | [parts by mass] | | Easy-adhesion surface | Untreated surface |
| Example 1 | **100** | **LA** | **10** | **0.3** | **A** | **C** |
| Example 2 | **100** | **DD2A** | **10** | **0.3** | **A** | **C** |
| Example 3 | **100** | **EEEA** | **5** | **0.15** | **A** | **C** |
| Example 4 | **100** | **POEA** | **5** | **0.15** | **A** | **C** |
| Example 5 | **100** | **4EG2A** | **50** | **1.5** | **A** | **A** |
| Example 6 | **100** | **14EG2A** | **50** | **1.5** | **A** | **A** |
| Example 7 | **100** | **G3A-20E** | **10** | **0.3** | **A** | **C** |
| Example 8 | **100** | **P4A-4E** | **30** | **0.9** | **A** | **A** |
| Example 9 | **100** | **DP6A-12E** | **5** | **0.15** | **A** | **C** |
| Example 10 | **100** | **UA4200** | **10** | **0.3** | **A** | **C** |
| Example 11 | **100** | **UV7605B** | **5** | **0.15** | **A** | **A** |
| Example 12 | **100** | **DEAA** | **30** | **0.9** | **B** | **C** |
| Example 14 | **100** | **8UH** | **50** | **1.5** | **A** | **A** |
| Example 15 | **100** | **8KX** | **50** | **1.5** | **A** | **A** |
| Comparative Example 1 | **100** | **None** | **-** | **None** | **C** | **C** |

As shown in Table 1, it was confirmed that in all of the plating films (Examples 1 to 12) formed using the primer of the present invention, the adhesion is excellent on the easy-adhesion surface of the PEN film. Furthermore, in Examples 5, 6, 8, 11, 14, and 15, the adhesion is high even on the untreated surface.

By contrast, the primer (Comparative Example 1) that does not include the polymerizable compound does not impart adhesion regardless of the easy-adhesion surface or the untreated surface of PEN.

Based on the results as described above, it was confirmed that the primer of the present invention can be used to obtain a plating film having excellent adhesion.

### [Example 13]

Ten fine lines having a length of 30 mm were drawn at intervals of 100 µm on the easy-adhesion surface of the PEN film, using the primer prepared in Example 11 with an inkjet system with drive waveform: A, repetition frequency: 1.3 kHz, stage speed: 20 mm/second, and liquid drop intervals of 15 µm. The drive voltage was adjusted from 4 V to 6 V such that liquid drop deflection did not occur while the flying droplets of the liquid were observed.

The film having the fine lines drawn thereon was dried on a hot plate at 80°C for 1 minute and then on a hot plate at 150°C for 5 minutes to obtain a base material having a priming layer in a shape of fine lines on the base material. The resultant priming layer was cured by radiating UV light with exposure energy of 800 mJ/cm² under an air atmosphere for exposure.

The resultant base material was immersed in the electroless copper plating solution prepared in Reference Example 1 and heated to 40°C, for 10 minutes. Subsequently, the base material was taken out and washed with water, and dried on a hot plate at 120°C for 10 minutes to obtain a plated base material.

The digital microscopic image of the obtained copper plating pattern on the base material subjected to electroless plating was observed, and a rectilinear fine line pattern with an average line width of 29 µm was observed.

## Claims

1. A photocurable primer for forming a metal plating film on a base material through an electroless plating process, the primer comprising:
(a) a hyperbranched polymer having an ammonium group at a molecular terminal and a weight average molecular weight of 1,000 to 5,000,000;
(b) metal fine particles;
(c) a polymerizable compound having a (meth)acryloyl group and having at least one structure selected from the group consisting of an oxyalkylene structure and a poly(meth)acrylic structure; and
(d) a photopolymerization initiator.

2. The photocurable primer according to claim 1, wherein the polymerizable compound (c) is a compound having a (meth)acryloyl group and having an oxyalkylene structure.

3. The photocurable primer according to claim 1, wherein the polymerizable compound (c) is a poly(meth)acrylic compound having a (meth)acryloyl group.

4. The photocurable primer according to any one of claims 1 to 3, wherein the polymerizable compound (c) is a compound having two or more (meth)acryloyl groups in a molecule.

5. The photocurable primer according to any one of claims 1 to 4, wherein the hyperbranched polymer (a) is a hyperbranched polymer of Formula [1]: 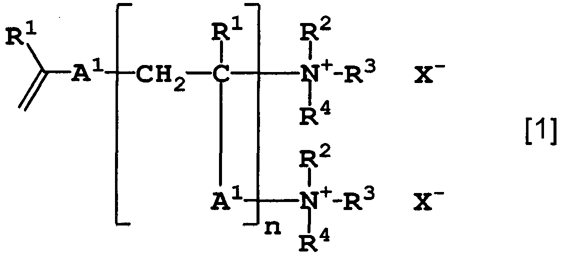 (wherein R¹ are each independently a hydrogen atom or a methyl group, R² to R⁴ are each independently a hydrogen atom, a linear, branched, or cyclic alkyl group having a carbon atom number of 1 to 20, a C₇₋₂₀ arylalkyl group, or -(CH₂CH₂O)ₘR⁵ (wherein R⁵ is a hydrogen atom or methyl group, and m is an integer of 2 to 100) (the alkyl group and the arylalkyl group are optionally substituted with an alkoxy group, a hydroxy group, an ammonium group, a carboxy group, or a cyano group), or optionally, two groups of R² to R⁴ together are a linear, branched, or cyclic alkylene group, or R² to R⁴ together with a nitrogen atom to which R² to R⁴ are bonded form a ring, X⁻ is an anion, n is number of repeating unit structures and an integer of 5 to 100,000, and A¹ is a structure of Formula [2]): 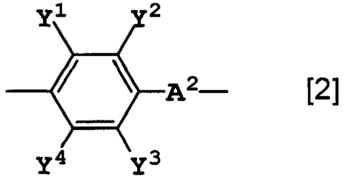 (wherein A² is a linear, branched, or cyclic alkylene group having a carbon atom number of 1 to 30 optionally containing an ether bond or an ester bond, and Y¹ to Y⁴ are each independently a hydrogen atom, a C₁₋₂₀ alkyl group, a C₁₋₂₀ alkoxy group, a nitro group, a hydroxy group, an amino group, a carboxy group, or a cyano group).

6. The photocurable primer according to claim 5, wherein the hyperbranched polymer (a) is a hyperbranched polymer of Formula [3]: 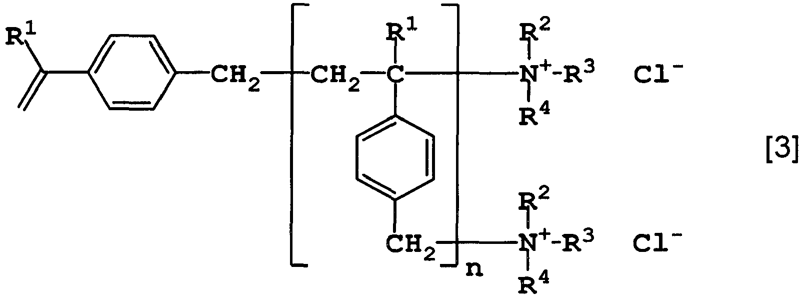 (wherein R¹ to R⁴ and n have the same meanings as described above).

7. The photocurable primer according to any one of claims 1 to 6, wherein the metal fine particles (b) are fine particles of at least one of metal species selected from the group consisting of iron (Fe), cobalt (Co), nickel (Ni), copper (Cu), palladium (Pd), silver (Ag), tin (Sn), platinum (Pt), and gold (Au).

8. The photocurable primer according to claim 7, wherein the metal fine particles (b) are palladium fine particles.

9. The photocurable primer according to any one of claims 1 to 8, wherein the metal fine particles (b) are fine particles having an average particle diameter of 1 nm to 100 nm.

10. A priming layer for electroless plating obtained by forming the photocurable primer as claimed in any one of claims 1 to 9 into a layer by photocuring.

11. A metal plating film formed on the priming layer for electroless plating as claimed in claim 10 by performing electroless plating on the priming layer.

12. A metal-coated base material comprising:
a base material;
the priming layer for electroless plating as claimed in claim 10 formed on the base material; and
the metal plating film as claimed in claim 11 formed on the priming layer for electroless plating.

13. A method of producing a metal-coated base material, the method comprising:
step A: applying the photocurable primer as claimed in any one of claims 1 to 9 on a base material to form a coating film;
step B: exposing the base material on which the photocurable primer is applied to form a priming layer; and
step C: immersing the base material with the priming layer in an electroless plating bath to form a metal plating film.

## Patentansprüche

1. Photohärtbare Grundierung zum Bilden eines Metallabscheidungsfilms auf einem Basismaterial durch ein außenstromloses Abscheidungsverfahren, wobei die Grundierung umfasst:
(a) ein hyperverzweigtes Polymer, das eine Ammoniumgruppe an einem Molekülterminus aufweist und ein Molekulargewicht von 1.000 bis 5.000.000 aufweist;
(b) Metallfeinpartikel;
(c) eine polymerisierbare Verbindung, die eine (Meth)acryloylgruppe aufweist und mindestens eine Struktur, ausgewählt aus der Gruppe bestehend aus einer Oxyalkylenstruktur und einer Poly(meth)acrylstruktur, aufweist; und
(d) einen Photopolymerisationsinitiator.

2. Photohärtbare Grundierung gemäß Anspruch 1, wobei die polymerisierbare Verbindung (c) eine Verbindung ist, die eine (Meth)acryloylgruppe aufweist und eine Oxyalkylenstruktur aufweist.

3. Photohärtbare Grundierung gemäß Anspruch 1, wobei die polymerisierbare Verbindung (c) eine Poly(meth)acrylverbindung ist, die eine (Meth)acryloylgruppe aufweist.

4. Photohärtbare Grundierung gemäß einem der Ansprüche 1 bis 3, wobei die polymerisierbare Verbindung (c) eine Verbindung ist, die zwei oder mehr (Meth)acryloylgruppen in einem Molekül aufweist.

5. Photohärtbare Grundierung gemäß einem der Ansprüche 1 bis 4, wobei das hyperverzweigte Polymer (a) ein hyperverzweigtes Polymer der Formel [1] ist: 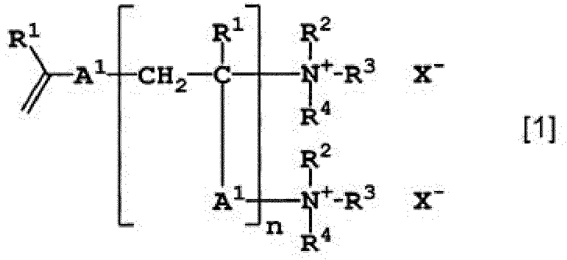 (wobei R¹ jeweils unabhängig ein Wasserstoffatom oder eine Methylgruppe sind, R² bis R⁴ jeweils unabhängig ein Wasserstoffatom, eine lineare, verzweigte oder cyclische Alkylgruppe mit einer Kohlenstoffatomanzahl von 1 bis 20, eine C₇₋₂₀-Arylakylgruppe oder -(CH₂CH₂O)ₘR⁵ sind (wobei R⁵ ein Wasserstoffatom oder Methylgruppe ist und m eine ganze Zahl von 2 bis 100 ist) (wobei die Alkylgruppe und die Arylalkylgruppe optional substituiert sind mit einer Alkoxygruppe, einer Hydroxygruppe, einer Ammoniumgruppe, einer Carboxygruppe oder einer Cyanogruppe) oder optional zwei Gruppen von R² bis R⁴ zusammen eine lineare, verzweigte oder cyclische Alkylengruppe sind oder R² bis R⁴ zusammen mit einem Stickstoffatom, an das R² bis R⁴ gebunden sind, einen Ring bilden, X⁻ ein Anion ist, n eine Anzahl von Wiederholungseinheitsstrukturen ist, n eine ganze Zahl von 5 bis 100.000 ist, und A¹ eine Struktur der Formel [2] ist): 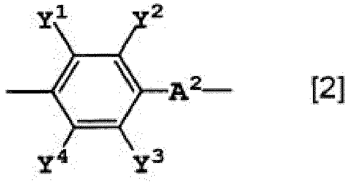 (wobei A² eine lineare, verzweigte oder cyclische Alkylengruppe mit einer Kohlenstoffatomanzahl von 1 bis 30 ist, die optional eine Etherbindung oder eine Esterbindung enthält, und Y¹ bis Y⁴ jeweils unabhängig ein Wasserstoffatom, eine C₁₋₂₀-Alkylgruppe, eine C₁₋₂₀-Alkoxygruppe, eine Nitrogruppe, eine Hydroxygruppe, eine Aminogruppe, eine Carboxygruppe oder eine Cyanogruppe sind).

6. Photohärtbare Grundierung gemäß Anspruch 5, wobei das hyperverzweigte Polymer (a) ein hyperverzweigtes Polymer der Formel [3] ist: 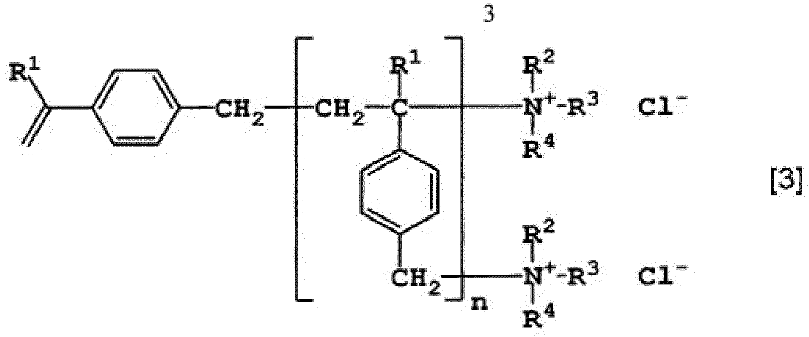 (wobei R¹ bis R⁴ und n die gleichen Bedeutungen wie oben beschriebe haben).

7. Photohärtbare Grundierung gemäß einem der Ansprüche 1 bis 6, wobei die Metallfeinpartikel (b) Feinpartikel mindestens einer Metallspezies, ausgewählt aus der Gruppe bestehend aus Eisen (Fe), Kobalt (Co), Nickel (Ni), Kupfer (Cu), Palladium (Pd), Silber (Ag), Zinn (Sn), Platin (Pt) und Gold (Au), sind.

8. Photohärtbare Grundierung gemäß Anspruch 7, wobei die Metallfeinpartikel (b) Palladiumfeinpartikel sind.

9. PhotohärtbarerGrundierung gemäß einem der Ansprüche 1 bis 8, wobei die Metallfeinpartikel (b) Feinpartikel mit einem durchschnittlichen Partikeldurchmesser von 1 nm bis 100 nm sind.

10. Grundierschicht zur außerstromlosen Abscheidung, erhalten durch Bilden der photohärtbaren Grundierung, wie in einem der Ansprüche 1 bis 9 beansprucht, in einer Schicht durch Photohärten.

11. Metallabscheidungsfilm, gebildet auf der Grundierschicht zur außerstromlosen Abscheidung, wie in Anspruch 10 beansprucht, durch Durchführen außenstromloser Abscheidung auf der Grundierschicht.

12. Metallbeschichtetes Basismaterial, umfassend:
ein Basismaterial;
die Grundierschicht zur außenstromlosen Abscheidung, wie in Anspruch 10 beansprucht, gebildet auf dem Basismaterial; und
den Metallabscheidungsfilm, wie in Anspruch 11 beansprucht, gebildet auf der Grundierschicht zur außenstromlosen Abscheidung.

13. Verfahren zum Herstellen eines metallbeschichteten Basismaterials, wobei das Verfahren umfasst:
Schritt A: Applizieren der photohärtbaren Grundierung, wie in einem der Ansprüche 1 bis 9 beansprucht, auf einem Basismaterial, so dass ein Beschichtungsfilm gebildet wird;
Schritt B: Exponieren des Basismaterials, auf dem die photohärtbare Grundierung appliziert wird, so dass eine Grundierschicht gebildet wird; und
Schritt C: Tauchen des Basismaterials mit der Grundierschicht in ein Bad zur außenstromlosen Abscheidung, so dass ein Metallabscheidungsfilm gebildet wird.

## Revendications

1. Primaire photodurcissable pour la formation d'un film de placage métallique sur un matériau de base par un procédé de placage sans électrolyse, le primaire comprenant :
(a) un polymère hyper-ramifié ayant un groupe ammonium à une extrémité moléculaire et un poids moléculaire moyen en poids de 1000 à 5000000 ;
(b) des particules fines de métal ;
(c) un composé polymérisable ayant un groupe (méth)acryloyle et ayant au moins une structure choisie parmi le groupe constitué d'une structure oxyalkylène et une structure poly(méth)acrylique ; et
(d) un initiateur de polymérisation.

2. Le primaire photodurcissable selon la revendication 1, dans lequel le composé polymérisable (c) est un composé ayant un groupe (méth)acryloyle et ayant une structure oxyalkylène.

3. Le primaire photodurcissable selon la revendication 1, dans lequel le composé polymérisable (c) est un composé poly(méth)acrylique ayant un groupe (méth)acryloyle.

4. Le primaire photodurcissable selon l'une quelconque des revendications 1 à 3, dans lequel le composé polymérisable (c) est un composé ayant deux ou plus de deux groupes (méth)acryloyles dans une molécule.

5. Le primaire photodurcissable selon l'une quelconque des revendications 1 à 4, dans lequel le polymère hyper-ramifié (a) est un polymère hyper-ramifié de Formule [1] : 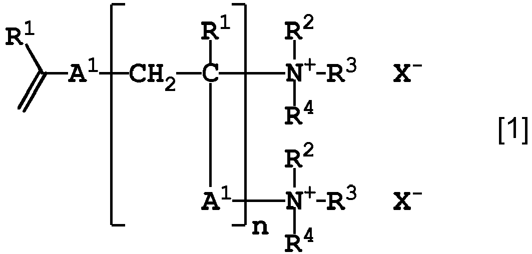 (dans laquelle R¹ sont chacun indépendamment un atome d'hydrogène ou un groupe méthyle, R² à R⁴ sont chacun indépendamment un atome d'hydrogène, un groupe alkyle linéaire, ramifié, ou cyclique ayant un nombre d'atomes de carbone de 1 à 20, un groupe arylalkyle en C₇₋₂₀, ou -(CH₂CH₂O)ₘR⁵ (où R⁵ est un atome d'hydrogène ou un groupe méthyle, et m est un entier de 2 à 100) (le groupe alkyle et le groupe arylalkyle sont optionnellement substitués avec un groupe alkoxy, un groupe hydroxy, un groupe ammonium, un groupe carboxy, ou un groupe cyano), ou optionnellement, deux des groupes R² à R⁴ ensemble sont un groupe alkylène linéaire, ramifié, ou cyclique, ou R² à R⁴ ensemble avec un atome d'azote auquel R² à R⁴ sont liés forment un cycle, X⁻ est un anion, n est le nombre de structures d'unité de répétition et un entier de 5 à 100000, et A¹ est une structure de Formule [2]) : 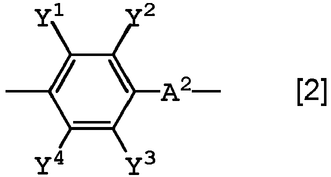 (dans laquelle A² est un groupe alkylène linéaire, ramifié, ou cyclique ayant un nombre d'atomes de carbone de 1 à 30 optionnellement contenant une liaison éther ou une liaison ester, et Y¹ à Y⁴ sont chacun indépendamment un atome d'hydrogène, un groupe alkyle en C₁₋₂₀, un groupe alkoxy en C₁₋₂₀, un groupe nitro, un groupe hydroxy, un groupe amino, un groupe carboxy, ou un groupe cyano).

6. Le primaire photodurcissable selon la revendication 5, dans lequel le polymère hyper-ramifié (a) est un polymère hyper-ramifié de Formule [3] : 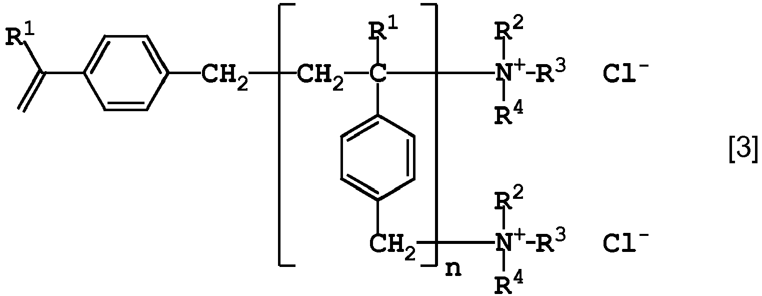 (dans laquelle R¹ à R⁴ et n ont les mêmes significations que décrites ci-dessus).

7. Le primaire photodurcissable selon l'une quelconque des revendications 1 à 6, dans lequel les particules fines de métal (b) sont des particules fines d'au moins un espèce métallique choisie parmi le groupe constitué du fer (Fe), du cobalt (Co), du nickel (Ni), du cuivre (Cu), du palladium (Pd), de l'argent (Ag), de l'étain (Sn), du platine (Pt), et de l'or (Au).

8. Le primaire photodurcissable selon la revendication 7, dans lequel les particules fines de métal (b) sont des particules fines de palladium.

9. Le primaire photodurcissable selon l'une quelconque des revendications 1 à 8, dans lequel les particules fines de métal (b) sont des particules fines ayant un diamètre de particule moyen de 1 nm à 100 nm.

10. Couche primaire pour placage sans électrolyse obtenue en formant le primaire photodurcissable selon l'une quelconque des revendications 1 à 9 en une couche par photodurcissement.

11. Film de placage métallique formé sur la couche primaire pour placage sans électrolyse telle que revendiquée dans la revendication 10 en réalisant un placage sans électrolyse sur la couche primaire.

12. Matériau de base à revêtement métallique comprenant :
un matériau de base ;
la couche de primaire pour placage sans électrolyse elle que revendiquée dans la revendication 10 formée sur la matériau de base ; et
le fil de placage métallique telle que revendiqué dans la revendication 11 formé sur la couche de primaire pour placage sans électrolyse.

13. Procédé de production d'un matériau de base à revêtement métallique, le procédé comprenant :
étape (A) : application du primaire photodurcissable telle que revendiqué dans l'une quelconque des revendications 1 à 9 sur un matériau de base pour former un film de revêtement ;
étape (B) : exposition du matériau de base sur lequel le primaire photodurcissable est appliqué pour former une couche primaire ; et
étape (C) : immersion du matériau de vase avec la couche primaire dans un bain de placage sans électrolyse pour former un film de placage métallique.
